# FASCICULE DE BREVET EUROPEEN

(11) **EP 4 630 365 B1**
(45) Date de publication et mention de la délivrance du brevet: **09.09.2026**
(21) Numéro de dépôt: 23821603.0
(22) Date de dépôt: 08.12.2023
(51) Int. Cl.: B81C 1/00, B01L 3/00, B01J 19/00

(54) **PROCÉDÉ DE FABRICATION D'UN DISPOSITIF FLUIDIQUE COMPORTANT UN SUBSTRAT PORTANT AU MOINS UN ELEMENT SOLIDE POREUX OU CREUX**
VERFAHREN ZUR HERSTELLUNG EINER FLUIDISCHEN VORRICHTUNG MIT EINEM SUBSTRAT MIT MINDESTENS EINEM PORÖSEN ODER HOHLEN FESTKÖRPERELEMENT
METHOD FOR MANUFACTURING A FLUIDIC DEVICE COMPRISING A SUBSTRATE BEARING AT LEAST ONE POROUS OR HOLLOW SOLID ELEMENT

(30) Priorité: 09.12.2022 FR 2213105
(43) Date de publication de la demande: 15.10.2025
(73) Titulaire: Commissariat à l'Energie Atomique et aux Energies Alternatives, 75015 Paris (FR); Centre National de la Recherche Scientifique, 75016 Paris (FR)
(72) Inventeur: MUGHERLI, Laurent, 91191 GIF-SUR-YVETTE CEDEX (FR); MALEVAL, Marc, 91191 GIF-SUR-YVETTE CEDEX (FR); MALLOGGI, Florent, 91191 GIF-SUR-YVETTE CEDEX (FR)
(74) Mandataire: Ipsilon
(86) Numéro de dépôt international: PCT/EP2023/084981
(87) Numéro de publication internationale: WO 2024/121419

(56) Documents cités:
- US-A1- 2004 226 620
- US-A1- 2011 270 412
- US-A1- 2016 040 940
- US-A1- 2020 047 399

## Description

La présente invention concerne un procédé de fabrication d'un dispositif pour la circulation d'un fluide sur au moins un chemin de circulation fluidique passant à travers un élément solide creux ou poreux et au moins une partie d'un circuit fluidique.

### Domaine technique

L'intégration d'éléments poreux ou creux, dans des dispositifs fluidiques, notamment microfluidique, est un défi car il est nécessaire de positionner l'élément poreux ou creux précisément dans le dispositif pour garantir (i) la connexion avec le circuit fluidique (ii) la circulation de fluide dans l'élément poreux ou creux (iii) le maintien des propriétés de l'élément poreux ou creux, notamment l'intégrité des pores ou des creux et/ou la perméabilité de l'élément poreux ou creux, mais aussi sa fonction de séparation ou de catalyse par exemple.

La plupart des procédés de fabrication de dispositif fluidique permettent de générer des zones ouvertes, notamment des canaux, dans un matériau solide au moyen d'au moins une étape impliquant l'utilisation d'un précurseur liquide qui se solidifie ensuite pour former une paroi étanche entre les zones ouvertes et le matériau solide. La solidification du précurseur liquide est obtenue notamment par polymérisation, par exemple lors de la fabrication des puces en PDMS ou suite à un refroidissement après un chauffage au-dessus de la transition vitreuse du polymère à l'instar des puces faites à partir de thermoplastique moulé.

Pour ces procédés, une première approche, qualifiée de méthode *« ex-situ »,* consiste à positionner un élément poreux ou creux avant de fabriquer la puce. Cependant, par cette méthode, le précurseur liquide va naturellement envahir les espaces ouverts, et ne pourra plus être retiré une fois solidifié, ce qui empêchera la circulation du liquide dans l'élément poreux ou creux après solidification. Ce problème est particulièrement prégnant pour des éléments de petites tailles compatibles avec des systèmes miniaturisés, mais il peut aussi se rencontrer pour des éléments poreux ou creux de plus grande taille qu'on souhaiterait encapsuler avec un liquide qui solidifie pour obtenir une meilleure étanchéité que par utilisation et application d'une gaine thermorétractable, par exemple pour des formes complexes ou présentant des arêtes saillantes. Cette pénétration du liquide dans les espaces ouverts est non seulement gênante pour les matériaux creux ou poreux, mais est aussi limitante pour le raccordement de ces éléments à la circulation fluidique. Cela rend notamment nécessaire d'avoir un circuit fluidique de section parfaitement adaptée à l'élément poreux, ce dernier étant alors fixe, pour garantir que le liquide circulant dans le circuit le traverse inévitablement. Il est aussi nécessaire que l'élément poreux ou creux ne soit pas détérioré lors de son incorporation, en particulier qu'il conserve son intégrité, sa porosité et/ou son volume poreux ou creux.

Les solutions usuelles pour intégrer un élément solide creux ou poreux dans un canal fluidique font appel à l'insertion en force de l'élément solide dans un canal, ou bien à des gaines qui épousent la forme du matériau, notamment des gaines thermorétractables, comme cela est décrit dans l'article Namera et al., Trends in Analytical chemistry, vol 45, 2013 ; Nakanishi, Wiley, Synthesis Concepts and Preparation of Silica Monoliths, 2011 - 10.1002/9783527633241.ch2. Ces méthodes sont limitées par les contraintes mécaniques qui s'appliquent sur l'élément, en particulier lorsque celui-ci est de petite taille. Par exemple, des monolithes à porosité hiérarchique cylindriques de plus de 3 mm de diamètre, peuvent être placées dans des gaines thermorétractables, mais pour des diamètres inférieurs à 3 mm, des problèmes tels que la détérioration du matériau suite à la rétractation de la gaine sont constatés.

Il est décrit dans Han et al. Microsystems & Nanoengineering 2019, 5:30 des éléments poreux encapsulés dans des gaines qui sont ensuite inclues dans du polyméthacrylate de méthyle acrylique (PMMA) par exemple, mais pour des architectures très simples impliquant un unique canal. La solution d'intégration dans des gaines solides est techniquement extrêmement limitante pour réaliser des dispositifs fluidiques, en particulier si une ou plusieurs fonctions doivent être intégrées dans une architecture fluidique complexe. C'est encore plus vrai dans le cas de fonctions nécessitant à elles seules des architectures complexes, comme l'intégration d'éléments mobiles, ou de contraintes optiques par exemple.

Il est connu des demandes US 7651762 B2 et WO2004/039495, la fabrication de gaines via des liquides qui solidifient. Ceci est une alternative qui permet d'épouser parfaitement la forme des éléments poreux ou creux. Ce type de méthode est notamment utilisée pour fabriquer certaines colonnes chromatographiques de diamètres supérieurs à 1 mm. Cependant, plus le matériau est de faible diamètre, plus les méthodes fondées sur des liquides qui solidifient sont difficiles à mettre en œuvre, notamment du fait de la pénétration du liquide dans une partie des pores ou espaces ouverts. C'est un inconvénient majeur pour la miniaturisation et cela devient particulièrement rédhibitoire pour des éléments de faibles diamètres ou épaisseur, typiquement des cylindres de diamètres inférieurs ou égaux à 2 mm. De plus, de tels matériaux encapsulent complètement l'élément solide, ce qui empêche son intégration dans un circuit fluidique.

Une seconde méthode dite *« in-situ »,* consiste à intégrer après fabrication et solidification du dispositif fluidique, les différents éléments possédant des espaces ouverts, notamment des pores. Pour ce faire, les éléments poreux ou creux sont alors fabriqués directement dans le dispositif. La demande de brevet EP3017866B1 et l'article Wu et al, Anal. Chem. 2006, 78 (16), 5704-5710 décrivent de telles fabrications in situ. Néanmoins, outre le fait que la taille des éléments poreux ou creux générés peut être difficilement contrôlable, les propriétés de porosité et de structure de l'élément poreux ou creux peuvent être difficilement reproductibles et une perte d'étanchéité entre l'élément poreux ou creux et le dispositif fluidique peut avoir lieu. De telles problématiques de maintien des propriétés, d'étanchéité et plus généralement de reproductibilité se retrouvent également dans la littérature portant sur la synthèse *in-situ* de matériaux poreux et c'est particulièrement le cas avec des monolithes obtenus par procédé sol-gel, pour lesquels l'intégration dans un simple capillaire de verre est déjà difficile, en atteste l'article Ishizuka et al., Journal of chromatography A (2002), 960 (1-2), 85-96.

Pour la fabrication des dispositifs fluidiques, il est connu de la demande internationale WO2019/077144, l'utilisation d'une encre sacrificielle pour tracer le circuit fluidique sur un support avant de la recouvrir par un polymère réticulable et l'élimination, après solidification du polymère, de l'encre pour former le circuit fluidique au sein de la structure en polymère réticulé.

Au vu des difficultés présentées précédemment, on comprend que l'obtention de dispositifs fluidiques intégrant des éléments poreux ou creux de designs complexes, par exemple associant plusieurs fonctions sur un espace réduit, est difficile.

Il existe donc un besoin pour un procédé de fabrication de dispositif fluidique permettant l'intégration d'un élément solide creux ou poreux qui soit simple, universel ou au moins compatible avec la majorité des procédés de fabrication des dispositifs fluidiques sans les complexifier, qui soit reproductible du point de vue de la circulation des fluides et des fonctionnalités et robuste. Ceci notamment afin de pouvoir réaliser à la fois des colonnes, des supports d'extraction, des catalyseurs, et des microsystèmes, sans nécessiter de redéployer une expertise et de la recherche pour réadapter les paramètres expérimentaux nécessaires en raison d'un changement de format et/ou de taille de l'élément poreux ou creux.

La demande US 2011/270412 A1 décrit un composant fluidique de taille millimétrique ou centimétrique ayant un chemin de circulation fluidique passant à travers un élément solide creux ou poreux. Il est connu de la demande US 2004/226620 A1, un procédé de fabrication des structures microfluidique en polymère utilisant une encre sacrificielle.

### Exposé de l'invention

Le procédé de l'invention est défini par la revendication 1.

L'invention répond à ce besoin à l'aide d'un procédé de fabrication d'un dispositif pour la circulation d'un fluide sur au moins un chemin de circulation fluidique passant à travers un élément solide creux ou poreux et au moins une partie d'un circuit fluidique, l'élément solide et la partie du circuit fluidique étant reliés fluidiquement entre eux, le procédé comprenant les étapes suivantes :
a) imprimer sur un support la trace du circuit fluidique avec une encre et disposer sur le support l'élément solide, l'encre étant jointive de l'élément solide sur le chemin de circulation fluidique,
b) recouvrir l'encre ayant solidifiée et l'élément solide avec un polymère réticulable, le polymère étant non-miscible avec l'encre solidifiée;
c) réticuler le polymère pour le solidifier; puis
d) extraire l'encre solidifiée pour former le chemin de circulation fluidique.

Par « *reliés fluidiquement entre eux »,* on comprend qu'un fluide peut passer de l'un à l'autre par une zone de circulation de fluide s'étendant entre les deux. De préférence, la liaison fluidique entre l'élément solide et le circuit fluidique se fait directement par le débouché d'au moins un pore, de préférence plusieurs pores, ou du ou d'au moins un creux de l'élément solide sur une portion du circuit fluidique.

Par « *imprimer sur un support le tracé du circuit fluidique avec une encre* », on comprend que l'encre est déposée sur le support pour reproduire le tracé du circuit fluidique sur le support, les zones en surépaisseur formés par l'encre représentant le tracé des zones en creux du circuit fluidique.

Par *« circulation d'un fluide sur un chemin de circulation fluidique passant à travers un élément solide creux ou poreux et au moins une partie d'un circuit fluidique »,* on comprend qu'après l'extraction de l'encre à l'étape d), il existe un chemin continu passant au travers de l'élément solide et d'au moins une partie du circuit fluidique par lequel un fluide est apte à circuler. Cela implique que l'élément solide conserve, après fabrication du dispositif, en son sein un chemin traversant par lequel un fluide peut circuler et que la liaison entre l'élément solide et le circuit fluidique permet la circulation de fluide de l'un à l'autre, la jonction entre l'encre et l'élément solide se faisant sur une surface de l'élément solide de laquelle débouche des pores ou au moins un creux de l'élément solide.

Par *« non-miscible »,* on comprend que l'encre solidifiée ne se mélange pas au polymère.

Un tel procédé permet l'intégration facile dans un circuit fluidique d'un élément solide poreux ou creux tout en permettant la circulation d'un fluide en son sein dans le circuit fluidique. L'encre permet la formation au sein du polymère d'une ou plusieurs microcavités et/ou d'un ou plusieurs microcanaux formant le circuit fluidique. En venant au contact de l'élément solide sur le chemin de circulation fluidique, l'élément solide est protégé à sa jonction avec l'encre d'un contact avec le polymère dans cette zone, ce qui empêche la pénétration du polymère dans le creux ou les pores au niveau de cette jonction lors de l'étape b) de recouvrement par le polymère. Ainsi, après l'étape d'extraction de l'encre, au moins l'une des microcavités ou un des microcanaux est directement relié fluidiquement au creux ou pores libres de la surface de circulation fluidique de l'élément solide.

L'extraction de l'encre à l'étape d) après solidification du polymère permet la formation des zones en creux du circuit fluidique définissant partiellement le chemin fluidique dans le polymère solidifié. La jonction entre l'encre et l'élément poreux sur le chemin de circulation fluidique à l'étape a) permet de laisser à cette jonction une zone de passage du fluide de l'élément solide vers le circuit formé par extraction de l'encre, la circulation du fluide n'étant pas bloquée par le polymère à cette jonction du fait de la présence de l'encre.

L'élément solide peut être disposé sur le support dans une zone prédéterminée du support, la zone prédéterminée étant déterminée pour que l'élément solide soit sur le chemin de circulation fluidique et que l'élément solide soit jointif d'au moins une partie du circuit fluidique.

### Procédé

### Maintien d'un chemin de circulation fluidique

De préférence, le procédé comporte une étape de protection d'au moins une partie des pores ou du ou des creux de l'élément solide le long du chemin de circulation fluidique. L'étape de protection peut comporter le remplissage préalable à l'étape de recouvrement b) d'au moins une partie de l'élément solide, notamment le cœur de l'élément solide, mieux tout l'élément solide, par un agent protecteur empêchant la pénétration du polymère dans l'élément solide à l'étape de recouvrement b) et une étape d'extraction de l'agent protecteur après l'étape de réticulation du polymère c) pour permettre la circulation fluidique dans l'élément solide. De préférence, l'agent protecteur est liquide lors de son introduction dans l'élément solide et se solidifie avant le recouvrement de l'élément solide par le polymère. L'élément solide peut être refroidi à une température inférieure à la température de solidification de l'agent protecteur.

De préférence, l'agent protecteur solidifié est non-miscible avec le polymère. L'agent protecteur solidifié peut être extrait avant, en même temps ou après l'extraction de l'encre. De préférence, l'agent protecteur est extrait simultanément à l'extraction de l'encre par la même méthode d'extraction.

Le remplissage d'au moins une partie de l'élément solide, notamment le cœur de l'élément solide, mieux tout l'élément solide, par l'agent protecteur peut se faire avant l'étape a) d'impression de l'encre et disposition de l'élément solide.

De préférence, l'agent protecteur est miscible avec l'encre d'impression du circuit fluidique. Cela permet de faciliter la jonction entre l'élément solide et l'encre à l'étape b).

L'agent protecteur peut être identique à l'encre d'impression de la trace du circuit fluidique. Dans ce cas, le remplissage d'au moins une partie de l'élément solide, notamment le cœur de l'élément solide, mieux tout l'élément solide, par l'agent protecteur peut être préalable à l'impression de l'encre ou en variante, l'étape a) peut comporter la disposition de l'élément solide sur le support puis l'impression de l'encre sur le support de sorte que l'encre remplisse au moins une partie de l'élément solide, notamment le cœur de l'élément solide, mieux tout l'élément solide.

En variante, dans le cas d'un élément solide poreux, la réticulation du polymère a lieu avant que le polymère n'ait pu remplir les pores d'au moins une section de passage du chemin de circulation fluidique de l'élément solide.

Le procédé peut être configuré pour que le polymère pénètre, en dehors de la zone de surface de l'élément solide en contact avec l'encre, dans les pores de l'élément solide entre l'étape de recouvrement b) et celle de réticulation c) sur une épaisseur de peau de l'élément solide inférieure ou égale à 40%, mieux inférieure ou égale à 30%, encore mieux inférieure ou égale à 20%, préférentiellement inférieure ou égale à 10%, de la plus petite dimension de l'élément solide en chaque section de passage du chemin de circulation fluidique dans l'élément solide. Par *« section de passage du chemin de circulation fluidique dans l'élément solide »,* on comprend une section transversale au chemin de circulation fluidique dans l'élément solide. Ceci permet de laisser au sein de l'élément solide en chaque section de passage une zone au sein de l'élément solide de circulation de fluide le long du chemin fluidique.

### Etape a)

De préférence, le support est refroidi à une température inférieure à la température de solidification de l'encre.

L'impression de l'encre peut avoir lieu avant la disposition de l'élément poreux ou creux sur le support ou inversement après la disposition de l'élément poreux ou creux sur le support.

La trace peut être continue ou discontinue. Elle peut comporter une pluralité de portions continues d'impression, les portions continues étant discontinues entre elles, notamment reliées entre elles par l'élément solide et/ou des éléments solides complémentaires.

Le procédé peut comporter un traitement préalable du support pour améliorer sa force d'adhésion avec l'encre à déposer et/ou le polymère destiné à former l'enveloppe.

L'impression de l'encre peut se faire par impression par jet d'encre, au moyen d'une buse d'impression et d'une encre liquide dont la viscosité est inférieure ou égale à 30 mPa.s⁻¹. La distance entre d'une part, ladite buse d'impression et d'autre part, le support peut être comprise entre 0,5 mm et 20 mm. La taille d'une goutte d'encre éjectée par ladite buse d'impression peut être comprise entre 10 µm et 100µm. La fréquence d'éjection des gouttes d'encre de ladite buse peut être comprise entre 50Hz et 5kHz. Le support d'une part et ladite buse d'impression d'autre part, peuvent être adaptés pour autoriser un déplacement relatif de l'un par rapport à l'autre avec une vitesse de déplacement relative contrôlée, comprise entre 1mm/s et 100mm/s.

En variante, l'impression de l'encre s'effectue au moyen d'une seringue contenant l'encre. La distance entre d'une part, une extrémité de la seringue par laquelle l'encre est dispensée et d'autre part, le support, peut être comprise entre 0,1mm et 1mm. Le débit d'encre dispensé par l'extrémité de ladite seringue peut être compris entre 0,01 nl/s et 10 nl/s. Le support d'une part et, ladite extrémité de seringue d'autre part, peuvent être adaptés pour autoriser un déplacement relatif de l'un par rapport à l'autre avec une vitesse de déplacement relative contrôlée, comprise entre 0,1 mm/s et 10 mm/s.

L'impression peut se faire par impression sur une surface d'impression du support de préférence plane. En variante, la surface d'impression peut être courbe, notamment concave ou convexe

Le procédé peut comporter l'impression localement d'une pluralité de couches d'encre successives les unes sur les autres après solidification de l'encre entre chaque couche pour obtenir une épaisseur de l'encre imprimée sur le support prédéterminé et ainsi obtenir une profondeur locale d'une structure du circuit fluidique prédéterminée. Cela permet l'obtention d'une très grande quantité d'architectures de dispositifs en lien avec des éléments solides très différents et rend ainsi le procédé versatile.

L'étape d'impression de la trace et de disposition de l'élément solide peut comporter une première impression d'encre pour former la trace du circuit fluidique, la disposition de l'élément solide sur le support, puis une deuxième impression d'encre, notamment à la jonction entre l'élément solide et la première impression d'encre pour former la jonction entre l'élément solide et l'encre de la première impression. Cette méthode permet d' avoir une jonction entre l'élément solide et l'encre qui empêche la pénétration du polymère entre les deux. Par ailleurs, cela permet d'avoir une bonne jonction malgré les imperfections de fabrication et améliore, de ce fait, la reproductibilité du procédé. Enfin, cela permet le blocage en position de l'élément poreux, notamment durant l'ajout du polymère, ce qui améliore encore la bonne formation du chemin de circulation fluidique.

De préférence, l'épaisseur de l'encre à la jonction avec l'élément solide est sensiblement égale à l'épaisseur de l'élément solide à la même jonction. De préférence, la section transversale de l'encre déposée à la jonction est sensiblement égale à la section transversale de l'élément solide à la jonction. En variante, les sections sont différentes.

En variante, le procédé peut comporter l'impression d'au moins deux portions chacune continues et disjointes entre elles pour former la trace du circuit fluidique, et la disposition de l'élément solide au moins partiellement entre les deux structures continues. Cela permet de former une jonction par un élément solide entre les deux portions continues qui, après extraction de l'encre formeront des conduits. Le chemin de circulation fluidique passera alors donc nécessairement par les pores ou le creux de l'élément solide entre les deux portions.

L'élément solide peut être disposé à cheval sur les deux portions continues. Dans ce mode de réalisation, chaque extrémité de l'élément solide peut s'étendre sur une des deux portions continues. Les deux portions continues peuvent comporter des encoches de réception des extrémités de l'élément solide. Cela permet notamment de surélever l'élément solide par rapport au support, les deux portions continues formant des cales de surélévation lors de la fabrication. Ainsi, lors du recouvrement par le polymère, une partie du polymère se répandra sous l'élément solide entre les deux portions continues de sorte que l'élément solide sera encapsulé dans le polymère et non en surface de ce dernier. Cela permet notamment un maintien de l'élément solide lors de l'extraction de l'encre pour former le chemin de circulation fluidique comme nous le verrons par la suite. Cela permet d'améliorer la tenue de l'élément solide sur les portions et la jonction fluidique au niveau des extrémités de l'élément solide en améliorant le contact entre l'encre et l'élément solide.

Par ailleurs, il est préférable dans ce cas de prévoir deux impressions, comme expliqué précédemment, une avant la disposition de l'élément solide et une après pour améliorer la tenue de l'élément solide lors de l'insertion du polymère ainsi que la jonction entre l'élément solide et l'encre.

Le procédé peut comporter une étape de solidification de l'encre et/ou de l'agent protecteur avant le recouvrement par le polymère en étape b). Cette étape peut être spontanée au vu de la nature de l'encre et/ou de l'agent protecteur, notamment par attente d'un temps de solidification, notamment d'évaporation d'un solvant, ou être contrôlée, notamment par chauffage.

Le procédé peut comporter, entre les étapes a) et b) un recuit à une température inférieure à la température d'extraction de l'encre et, le cas échéant, de l'agent protecteur. Un tel recuit permet de diminuer la rugosité de la surface de la trace déposée. En effet, une fois l'encre solidifiée et malgré le soin apporté aux conditions de dépôt, on peut constater que la surface de l'encre, sous forme solide, présente une rugosité significative. En conséquence, cette rugosité pourra se retrouver sur les parois polymère du circuit fluidique. La rugosité peut avoir un effet non négligeable sur les conditions d'écoulement dans le dispositif et par suite, générer des pertes de charge et/ou des échanges thermiques indésirables ou modifier les conditions d'analyse.

Le procédé peut comporter la disposition de plusieurs éléments solides poreux et/ou creux à l'étape a), les éléments solides étant chacun jointifs de l'encre imprimée le long du chemin de circulation fluidique. Les éléments solides peuvent être reliés fluidiquement entre eux en série ou en parallèle par une ou plusieurs portions continues du circuit fluidique le long du chemin de circulation fluidique. Les éléments solides peuvent être sensiblement de mêmes dimensions, structure et/ou porosité ou en variante être différents par leurs dimensions, structure et/ou porosité. Les portions continues du circuit fluidique peuvent former des jonctions entre plusieurs éléments solides, notamment de natures différentes, plus précisément entre un élément solide en creux formant un canal et un élément solide poreux.

Le procédé peut comporter l'ajout d'un ou plusieurs éléments complémentaires solides à l'étape a). Le ou les éléments complémentaires peuvent être choisis parmi :
- des éléments de connectique pour permettre la circulation du fluide dans le circuit fluidique, notamment pour connecter le circuit fluidique à l'entrée ou la sortie de fluide ou pour relier le dispositif à un autre dispositif identique ou différent, et/ou
- des éléments d'agencement de l'élément solide sur le support, notamment des cales chacune disposée au moins partiellement sous au moins une partie l'élément solide, notamment sous chacune de ses extrémités.

### Recouvrement

L'étape de recouvrement de l'élément solide et de l'encre solidifiée par le polymère peut s'effectuer en coulant le polymère sur le support, l'élément solide et l'encre solidifiée imprimée.

Le polymère introduit à l'étape b) peut comporter : le polydiméthylsiloxane (PDMS), les polyimides, les gels d'agarose ou une colle telle que l'acrylique ou leurs mélanges.

Le polymère peut comporter un additif de réticulation. L'additif peut être un agent réticulant, notamment le méthylhydrosiloxane, un photoinitiateur, notamment le 1-Hydroxy-cyclohexyl-phenyl-kétone ou benzophénone ou quinone ou un solvant, notamment le formaldéhyde.

Dans le cas où l'additif est un agent réticulant, et en fonction de la nature de ce réticulant et/ou du polymère, la réticulation peut s'effectuer à température ambiante, éventuellement aidé par un faible chauffage pour accélérer la réticulation. Toujours lorsque l'additif est un agent réticulant, et si la nature du réticulant et/ou celle du polymère n'autorise pas une réticulation à température ambiante, la réticulation peut s'effectuer par chauffage, notamment à une température inférieure à la température d'extraction de l'encre à pression équivalente et le cas échéant du liquide protecteur.

Dans le cas où l'additif est un photo-initiateur, la réticulation peut s'effectuer en soumettant le polymère à un rayonnement ultraviolet. Un photo-initiateur peut notamment être envisagé avec certaines colles, qui deviennent alors réticulables par ultraviolets.

Enfin, dans le cas où l'additif est un solvant, la réticulation comporte l'évaporation du solvant, qui s'effectue généralement à température ambiante. Une fois évaporation du solvant effectué, le polymère réticule.

La réticulation du polymère est de préférence contrôlée de sorte que le temps de réticulation soit inférieur au temps de remplissage de l'élément solide poreux par le polymère. Le contrôle du temps de réticulation peut se faire par le contrôle de la température et/ou de la pression à laquelle le polymère est réticulé.

### Extraction

L'extraction de l'encre et, le cas échéant, de l'agent protecteur peut se faire par toute technique préservant l'intégrité de l'élément solide et du polymère réticulé. De préférence, l'extraction de l'encre, et, le cas échéant, de l'agent protecteur, se fait par passage de l'encre et, le cas échéant, de l'agent protecteur en phase vapeur puis évacuation de la vapeur.

L'extraction de l'encre et/ou de l'agent protecteur peut se faire, notamment selon la nature de l'encre et, le cas échéant, de l'agent protecteur, par la sublimation ou, selon la nature de l'encre et/ou de l'agent protecteur, la liquéfaction puis l'évaporation de l'encre et, le cas échéant, de l'agent protecteur solidifié. D'autres solutions d'extraction sont possibles tant qu'elles permettent l'extraction de l'encre pour former le chemin de circulation fluidique. Il est par exemple envisageable, selon la nature de l'encre et du polymère réticulable, une décomposition thermique par traitement thermique à une température de décomposition de l'encre inférieure à la température de fusion du polymère réticulable ou une dilution par la mise en circulation d'un produit de dilution de l'encre avec ou sans liquéfaction de l'encre préalable, un aspiration/surpression avec liquéfaction de l'encre préalable. De préférence, la température d'extraction de l'encre et, le cas échéant, de l'agent protecteur solidifié est inférieure à la température de fusion du polymère à pression équivalente.

Ainsi, pour sublimer l'encre et, le cas échéant, l'agent protecteur, l'étape d'extraction peut s'effectuer par chauffage et en appliquant un différentiel de pression entre l'intérieur de l'ensemble formé à l'issue de l'étape c) et l'extérieur. Ceci permet de se placer, dans le diagramme de phase de l'encre et, le cas échéant, de l'agent protecteur, sur un couple pression et température permettant directement le passage de l'état solide à l'état vapeur. Lorsque cela est envisageable, c'est particulièrement avantageux car on limite le niveau de chauffage de l'ensemble formé à l'étape c), et donc l'énergie dépensée, pour mettre l'encre et, le cas échéant, l'agent protecteur sous forme de vapeur et donc l'éliminer afin de former le chemin de circulation fluidique.

En variante, l'étape d'extraction d) est réalisée par chauffage afin d'assurer la liquéfaction, puis la vaporisation de l'encre et, le cas échéant, de l'agent protecteur.

Le procédé peut comporter le lavage du dispositif après extraction de l'encre et/ou de l'agent protecteur par circulation d'un liquide de lavage dans le dispositif le long du chemin de circulation fluidique. Le procédé peut comporter une étape de séchage du dispositif après le lavage.

Le procédé peut comporter avant ou après le recouvrement par le polymère et avant ou après l'extraction l'ajout de structures additionnelles sur ou dans le polymère, notamment de structure de piquage dans le polymère pour relier le circuit fluidique dans le polymère à l'extérieur.

En variante, lorsque l'encre est déposée au moins partiellement en contact du support, l'extraction de l'encre peut comporter
- la séparation du support initial de l'ensemble formé au moins du polymère réticulé, de l'encre et l'élément solide formant un seul bloc, puis
- l'extraction de l'encre de l'ensemble, notamment par dissolution dans l'alcool et/ou vaporisation ou sublimation de l'encre comme décrit précédemment, et
- la mise en place de l'ensemble dont l'encre a été extraite pour former le circuit fluidique sur un support identique ou différent du support initial. La fixation sur ledit support peut se faire par adhésion du polymère sur le support, avec ou sans adhésif, ou tout autre méthode connue permettant une adhésion étanche sur le support.

Cette variante est plus particulièrement applicable lorsque l'élément solide est au moins partiellement encapsulé dans le polymère, l'élément solide étant surélevé par rapport au support. En effet, l'élément solide étant maintenu dans le polymère, il est alors plus facile de détacher et recoller l'ensemble du support, l'élément solide n'étant pas au contact de ce dernier. Dans le cas d'un élément solide affleurant le support, cette variante est également applicable mais non préféré.

### Support

Le support peut comporter un substrat en un matériau hydrophobe par exemple choisi parmi: les polyimides (PI), les silicones dont le polydiméthylsiloxane (PDMS), le polypropylène (PP), le polytétrafluoroéthylène (PTFE), le copolymère d'oléfine cyclique (COC) ou un matériau hydrophile choisi parmi le silicium, le verre, la cellulose, les fibres de verre.

Le substrat peut être rigide. Le substrat peut être multicouche.

La surface d'impression peut être une surface du substrat. La surface d'impression peut être plane. En variante, la surface d'impression est non plane, notamment courbe, en particulier concave ou convexe ou comporte des reliefs de surface.

Le procédé peut comporter le retrait d'au moins une partie du support, notamment du substrat.

En variante, le support comporte un substrat tel que décrit précédemment et un ou plusieurs éléments de support déposés sur le substrat. Les éléments de support, le cas échéant, peuvent être de même épaisseur, prise transversalement au plan d'extension du substrat. La surface d'impression peut comporter une surface externe de la ou de chaque élément de support. La ou les surfaces externes peuvent être planes. Les surfaces externes de la surface d'impression peuvent être coplanaires. Le procédé peut comporter une étape de formation du support par ajout du ou des éléments de support sur le substrat.

Le support peut comporter au moins deux éléments de support, notamment en un polymère réticulé identique à celui de l'étape b), sur le substrat espacé entre eux d'une distance non nulle, le dispositif étant configuré pour que l'élément solide soit disposé à l'étape a) à cheval sur les deux éléments de support et pour que l'impression de l'encre se fasse sur un ou les deux éléments de supports. Ce cas est particulièrement utile lorsque le substrat est retiré après l'étape c) ou d) comme cela est décrit ci-dessous car cela renforce la rigidité du dispositif en encapsulant l'élément solide et le circuit fluidique dans le polymère.

La surface de contact de l'élément solide avec le support peut être disposé au même niveau que la surface d'impression de l'encre.

En variante, le support comporte une cavité de réception de l'élément solide en surface configuré pour recevoir l'élément solide, l'élément solide (30) étant disposé dans la cavité à l'étape a). Une telle cavité permet le positionnement précis et facile de l'élément poreux sur le support. Elle permet également le maintien de l'élément poreux sur le support durant l'étape d'impression de l'encre et l'étape de recouvrement par le polymère. De préférence, la cavité de réception de l'élément solide présente une profondeur inférieure ou égale à la dimension de l'élément solide prise perpendiculairement au support, notamment à l'épaisseur de l'élément solide, ceci afin de permettre la jonction entre l'encre et l'élément solide pour former le circuit fluidique. La profondeur de la cavité de réception de l'élément solide peut être inférieure ou égale à 80%, mieux à 50% de la dimension de l'élément solide prise perpendiculairement au support. La cavité de réception de l'élément solide peut être formée par un renfoncement ou une tranchée sur le substrat ou sur une couche de polymère réticulé du support ajusté ou non à la forme de l'élément solide dans lequel l'élément solide est disposé à l'étape a). En variante, la cavité de réception de l'élément solide est délimitée par une pluralité d'éléments de surface, notamment en polymère réticulé identique à celui de l'étape b), agencés sur le substrat pour former la cavité de réception de l'élément solide. Dans ce cas, l'élément solide est disposé sur le substrat dans la cavité et est bordé au contact au moins sur un de ses côtés, mieux en au moins deux de ses côtés, encore mieux en au moins ses deux extrémités longitudinales, par les éléments de surface formant des surfaces d'impression de l'encre à l'étape a).

### Circuit fluidique

Le circuit fluidique peut comporter un canal et/ou une chambre, le canal ou la chambre étant jointif de l'élément solide le long du chemin de circulation fluidique.

Le circuit fluidique peut être un circuit microfluidique. Le circuit fluidique peut comporter au moins un microcanal et/ou au moins une chambre microfluidique. De préférence, l'élément solide est jointif d'un microcanal sur le chemin de circulation fluidique. Le fait d'avoir un circuit microfluidique permet de traiter des petits volumes, ce qui réduit le temps d'analyse, la consommation de liquide et par conséquent le coût.

Le circuit fluidique peut comporter deux canaux, reliant chacun fluidiquement une extrémité de l'élément solide, le chemin de circulation fluidique étant défini d'un microcanal à l'autre en passant au travers de l'élément solide.

Le circuit fluidique peut s'étendre selon un plan d'extension sensiblement parallèle à la surface d'impression.

Le circuit fluidique à la jonction avec l'élément solide peut présenter une section sensiblement égale à la section de l'élément solide avec laquelle il est joint. En variante, le circuit fluidique à la jonction avec l'élément solide peut présenter une section supérieure à la section de l'élément solide avec laquelle il est joint. Par exemple, le circuit fluidique peut comporter un canal s'étendant le long du plan d'extension sur le support et comportant à la jonction avec l'élément solide une extension verticale pour joindre l'extrémité de l'élément solide encapsulé dans le polymère réticulé. Dans ce cas, la hauteur du canal au niveau de l'extrémité de l'élément solide peut être supérieure ou égale à la somme de la hauteur de l'extrémité de l'élément solide avec laquelle il est joint et de la hauteur de surélévation de l'élément solide par rapport au support.

### Elément solide

L'élément solide peut être disposé au-dessus du support avec ou sans contact avec ce dernier. L'élément solide peut être disposé en contact avec le support, sur des cales agencées sur un substrat ou sans contact avec ce dernier sur une ou plusieurs portions continues d'impression.

L'élément solide peut s'étendre sur le chemin de circulation fluidique de sorte que le chemin de circulation fluidique traverse l'élément solide d'un point d'entrée à un point de sortie, le point d'entrée et le point de sortie étant espacés entre eux d'une distance supérieure ou égale à 0,5 mm, mieux supérieure ou égale à 1 mm, encore mieux supérieure ou égale à 2 mm. De préférence, le point d'entrée et le point de sortie sont espacés entre eux d'une distance supérieure ou égale à 10%, mieux 50%, encore mieux la totalité, de la plus grande dimension de l'élément solide. Le point d'entrée et le point de sortie peuvent être sur des faces opposées de l'élément solide, notamment à des extrémités opposées de l'élément solide.

De préférence, la droite entre les points d'entrée et de sortie du chemin de circulation fluidique s'étend parallèlement à la surface d'impression du support.

L'élément solide peut être agencé sur le chemin de circulation fluidique de sorte que la droite reliant les points d'entrée et de sortie du chemin de circulation fluidique dans l'élément solide s'étendent le long d'un axe médian de l'élément solide.

L'élément solide peut présenter une plus grande dimension, transversale à la droite reliant les points d'entrée et de sortie du chemin de circulation fluidique dans l'élément solide, notamment une épaisseur prise perpendiculaire au plan d'extension du support, inférieure ou égale à 10 mm, mieux inférieure ou égale à 5 mm, encore mieux inférieure ou égale à 2 mm, encore mieux inférieure ou égale à 1,5 mm, encore mieux inférieure ou égale à 1 mm. L'élément solide peut présenter une plus grande dimension, transversale à la droite reliant les points d'entrée et de sortie du chemin de circulation fluidique dans l'élément solide, notamment une épaisseur prise perpendiculaire au plan d'extension du support, supérieure ou égale à 20 µm (microns), mieux supérieure ou égale à 50µm, encore mieux supérieure ou égale à 100 µm, de préférence, supérieure ou égale à 200 µm.

De préférence, l'élément solide est cylindrique à base polygonale, ovale, triangulaire ou circulaire, notamment cylindrique de révolution.

L'élément solide peut être allongé selon un axe d'élongation rectiligne ou non et présenter une longueur supérieure ou égale à 0,5 mm, mieux supérieure ou égale à 1 mm, encore mieux supérieure ou égale à 2 mm, et/ou inférieure ou égale à 10 cm, mieux inférieure ou égale à 5 cm. L'axe d'élongation peut s'étendre sur un plan.

De préférence, le chemin de circulation fluidique traverse l'élément solide sur toute sa longueur.

De préférence, l'élément solide est cylindrique et de diamètre inférieur ou égal à 10 mm, mieux inférieur ou égal à 6 mm, et/ou de diamètre supérieur ou égal à 0,02 mm et/ou de longueur supérieure ou égale à 0,5 mm, mieux supérieur ou égal à 1 mm, encore mieux supérieur ou égal à 2 mm.

L'élément solide peut présenter un rapport de forme, défini comme le rapport de sa longueur sur sa plus grande dimension transversale, supérieur ou égal à 0,2, mieux supérieur ou égal à 0,4, mieux supérieur ou égal à 1 et/ou inférieur ou égal à 1000, mieux inférieur ou égal à 500, encore mieux inférieur ou égal à 100, mieux inférieur ou égal à 50, encore mieux inférieur ou égal à 20.

L'élément solide peut être agencé sur le support de sorte que le chemin de circulation fluidique traverse l'élément solide sur une longueur supérieure à l'épaisseur de l'élément solide, l'épaisseur étant prise perpendiculairement à la surface d'impression.

### Elément creux

L'élément solide peut être creux, les extrémités ouvertes aux deux extrémités du creux de l'élément solide étant sur le chemin de circulation fluidique et l'axe central du creux s'étendant le long du chemin de circulation fluidique. L'axe central du creux peut être rectiligne ou courbe. Dans le cas d'un élément solide creux, le maintien du chemin de circulation fluidique dans le creux peut se faire par bouchage des deux extrémités par un agent protecteur préalablement à l'ajout sur le support ou par l'encre du circuit fluidique jointe à l'extrémité creuse de l'élément solide durant l'étape a).

L'élément solide peut être un tube ou un capillaire en silice ou en verre ou en tout autre matériau compatible avec l'encre et le polymère utilisé lors de la réticulation. En variante, l'élément solide est un élément creux autre qu'un tube ou un capillaire. Il peut être une jonction fluidique, notamment en Y, T ou X, une valve, une vanne ou une gaine ou un élément creux de tout autre forme.

Le capillaire peut présenter un diamètre inférieur ou égal à 2 mm.

### Elément poreux

De préférence, l'élément solide est poreux.

L'élément solide comporte, de préférence, un monolithe poreux, notamment à porosité hiérarchique, c'est-à-dire présentant au moins deux ordres de grandeur de tailles de pores, de préférence des macropores tels que décrit précédemment formés durant une étape de formation de la matrice sol-gel et des mésopores tels que décrits précédemment formés durant une étape génération contrôlée de mésopores. Un tel monolithe poreux présente une bonne surface d'échange entre le fluide le traversant et sa matière et minimise les distances à parcourir par diffusion. De plus, ceci permet d'apporter une flexibilité au monolithe poreux tout en réduisant les risques de casse.

De préférence, l'élément solide comporte un monolithe poreux autoporté. Par *« autoporté »,* on comprend que le monolithe poreux est stable par sa seule rigidité et n'a besoin d'aucun support pour être suffisamment stable pour être manipulé.

Il peut être disposé nu sur le support. Par *« disposé nu sur le support»,* on comprend que le monolithe poreux ne comporte pas d'enveloppe additionnelle avant sa disposition sur le support et notamment ne comporte pas de gaine thermorétractable ou n'est pas reçu dans un conduit. En revanche, il peut être imprégné de l'agent protecteur tel que décrit précédemment.

En variante, l'élément solide comporte un monolithe poreux et une gaine extérieure de protection du monolithe poreux ouverte au niveau du point d'entrée et du point de sortie du chemin de circulation fluidique, l'encre étant jointive d'au moins une extrémité ouverte du tube ou du capillaire à l'étape a) du procédé. De préférence, le monolithe poreux et la gaine extérieure sont configurés pour que le chemin de circulation fluidique traverse le monolithe poreux sur une distance d'au moins 10%, mieux d'au moins 50%, encore mieux la totalité de la droite entre le point d'entrée et le point de sortie dans le monolithe poreux sur le chemin de circulation fluidique.

La gaine extérieure de protection peut être une gaine thermorétractable. Le procédé peut comporter l'insertion du monolithe poreux dans la gaine thermorétractable et le chauffage de la gaine pour la rétracter sur le monolithe poreux. Cela permet d'avoir une gaine rétractée sur le monolithe poreux qui soit ajustée sur ce dernier et assure que le chemin de circulation fluidique traverse bien le monolithe poreux.

En variante, la gaine extérieure est rigide. Elle peut être sous forme de tube ou de capillaire. De préférence, dans ce cas, le monolithe poreux est directement formé dans la gaine extérieure, notamment par le procédé sol-gel décrit ci-dessous. De préférence, dans le cas d'un capillaire, le diamètre du capillaire est inférieur ou égal à 2 mm.

Le monolithe poreux peut comporter des macropores, notamment des macropores de dimension supérieure ou égale à 50 nm. Les macropores peuvent présenter une dimension inférieure ou égale à 30 µm.

Le monolithe poreux peut comporter des mésopores, notamment de dimension inférieure ou égale à 50 nm, mieux comprise entre 2 et 50 nm. De préférence, les pores sont connectés entre eux dans le monolithe poreux.

Le monolithe poreux peut être de structure sensiblement homogène dans tout son volume.

Le monolithe poreux peut présenter une fonctionnalisation de surface de pores. La surface des pores du monolithe poreux peut être recouverte de composés tels que des ligands hydrocarbonés hydrophobes (par exemple des ligands octadécylique) ou tels que des ligands hydrophiles comme des dérivés 2,3dihydroxypropyle. Les ligands de tels monolithes poreux modifiés peuvent être encore modifiés en utilisant des procédures connues. Des catalyseurs poreux ou des supports d'enzymes peuvent être préparés en ajoutant des enzymes, par exemple de la glucose isomérase, ou des éléments métalliques catalytiques, par exemple platine et palladium.

### Procédé de formation du monolithe poreux

De préférence, le monolithe poreux est formé par un procédé sol-gel. Par « *procédé sol-gel »,* on comprend un procédé mis en œuvre en utilisant comme précurseurs des alcoxydes de formule M(OR)n, R'-M(OR)n-1 ou encore des silicates de sodium ou des colloïdes de titane, M étant un métal, un métal de transition ou un métalloïde, notamment le silicium, et R ou R' des groupements alkyles, n étant le degré d'oxydation du métal. En présence d'eau, l'hydrolyse des groupements alkoxy (OR) intervient, formant de petites particules de taille généralement inférieure à 1 nanomètre. Ces particules s'agrègent et forment des amas qui restent en suspension sans précipiter, et forment le sol. L'augmentation des amas et leur condensation augmente la viscosité du milieu et forme ce qui est appelé le gel. Le gel peut alors continuer à évoluer pendant une phase de vieillissement pendant laquelle le réseau polymérique présent au sein du gel se densifie. Le gel se rétracte ensuite en évacuant le solvant en dehors du réseau polymérique formé, lors d'une étape appelée la synérèse. Puis le solvant s'évapore, lors d'une étape dite de séchage, ce qui conduit à un matériau solide de type verre poreux donnant un monolithe poreux. Les étapes de synérèse et de séchage peuvent être concomitantes. Un tel procédé permet l'obtention d'un monolithe poreux de caractéristiques, notamment porosité et de distribution de taille de pores, contrôlées. Il permet également l'obtention d'une grande variété de formes.

De préférence, le procédé comporte la formation du monolithe poreux par un procédé de fabrication comportant :
- la formation d'un sol comportant un précurseur sol-gel en solution aqueuse et, de préférence, un agent porogène,
- le remplissage au moins partiel d'une enceinte et d'au moins un moule contenu dans l'enceinte en sol formé précédemment, le moule comportant au moins une ouverture s'ouvrant dans le sol après remplissage en sol,
- la formation d'une matrice sol-gel dans l'enceinte à partir du sol,
- l'extraction du moule avec la matrice sol-gel contenue dans le moule de l'enceinte, et
- la formation d'un monolithe poreux à partir de la matrice sol-gel,
la formation du sol, de la matrice sol-gel et du monolithe poreux se faisant par un procédé sol-gel.

Le procédé peut comporter l'extraction de la matrice sol-gel du moule avant ou après la formation du monolithe poreux.

La présence d'au moins une ouverture dans le moule sous le niveau de sol après remplissage permet le remplissage du moule par le sol durant l'étape de remplissage et la circulation fluidique du sol entre le sol contenu dans le moule et le sol contenu dans l'enceinte durant la suite du procédé. Le fait de réaliser une grande matrice sol-gel dans l'enceinte et d'en extraire une partie incluse dans un moule lors de la formation de la matrice permet de s'affranchir des effets de bord qui apparaissent dans les procédés décrits précédemment en réalisant la matrice sol-gel dans un récipient qui est toujours de même taille. Un tel procédé permet la fabrication de monolithes poreux, notamment autoportés, aux propriétés texturales similaires sur une gamme étendue de diamètres sans avoir à réoptimiser, voire modifier, la formulation du mélange initial. Il permet également d'accéder à une grande variété de formes et rapports d'aspects des monolithes, mais également à des structures internes, notamment de porosité et de distribution de la taille des pores, contrôlées variées et reproductibles. Les structures obtenues sont particulièrement uniformes et garantissent donc une homogénéité de résistance aux contraintes mécaniques. Ceci peut s'avérer utile par exemple pour éviter des cassures lorsqu'une pression est exercée sur le monolithe lors de son intégration dans le conduit fluidique, notamment lors de son encapsulation dans un conduit fluidique thermo-rétractable.

Le sol peut être formé par agitation d'une solution comportant le précurseur sol-gel, de préférence le précurseur sol-gel et l'agent porogène, notamment pendant une durée supérieure ou égale à 5 min, mieux supérieure ou égale à 10 min, encore mieux supérieure ou égale à 15 min. La durée de l'agitation peut être inférieure ou égale à 3h, mieux inférieure ou égale à 2h. Durant l'agitation, la température peut être contrôlée à une valeur prédéterminée sensiblement constante, notamment comprise entre 0°C et 90°C, mieux entre 0°C et 50°C.

Le remplissage peut se faire sans présence de bulles d'air et/ou de gradients de composition chimique et/ou de température du sol dans l'enceinte et le ou les moules.

La formation de la matrice sol-gel peut comporter la condensation pour former un gel et optionnellement le vieillissement au moins partiel pour densifier le gel.

De préférence, la formation de la matrice sol-gel dans l'enceinte est dépourvue de séchage de la matrice sol-gel.

La formation de la matrice sol-gel peut se faire de la même manière dans l'enceinte et le moule. La porosité totale et la taille des pores sont préférentiellement sensiblement homogènes dans l'enceinte et le ou les moules.

L'extraction du moule avec la matrice qu'il contient de l'enceinte peut comporter une extraction d'un bloc de la matrice sol-gel contenant le moule de l'enceinte et l'extraction du moule et de la matrice sol-gel qu'il contient du bloc extrait précédemment. L'extraction du ou de chaque moule du bloc peut se faire par coupure de la matrice sol-gel à fleur du moule correspondant ou casse de la matrice sol-gel entourant le ou les moules. En variante, l'extraction du ou de chaque moule avec la matrice qu'il contient peut se faire par retrait du moule correspondant de la matrice sol-gel l'entourant après extraction du bloc tel que décrit précédemment ou directement dans l'enceinte sans extraction préalable du bloc, notamment lorsque le moule correspondant n'est que partiellement immergé dans la matrice sol-gel.

L'extraction de la matrice sol-gel contenue dans le ou chaque moule peut se faire au moyen d'une pression contrôlée sur ladite matrice sol-gel, par exemple par pression directe avec un solide de dimension inférieure au moule ou par pression d'un gaz à débit contrôlé ou par ouverture du ou de chaque moule, notamment par découpe du ou de chaque moule ou séparation de deux parties du ou de chaque moule entre elles. Le ou les moules peuvent être sous forme de deux parties mobiles entre elles, notamment séparables ou mobiles l'une par rapport à l'autre grâce à une charnière.

Le moule contenant la matrice sol-gel peut être immergé dans un liquide lors de l'étape d'extraction de la matrice sol-gel contenue dans le moule. Ceci facilite l'extraction de la matrice sol-gel.

La formation du monolithe poreux peut comporter une génération contrôlée de mésoporosité dans la matrice sol-gel pour former une matrice sol-gel à porosité hiérarchique après l'extraction du moule de l'enceinte, et avant la formation du monolithe poreux à partir de la matrice sol-gel du moule. La génération contrôlée de mésoporosité peut se faire par immersion de la matrice sol-gel extraite ou non du ou de chaque moule dans une solution aqueuse de génération de la mésoporosité comportant un agent de dissolution de la matrice sol-gel et/ou un précurseur d'agent de dissolution de la matrice sol-gel. L'agent de dissolution peut être de l'hydroxyde d'ammonium, par exemple à une concentration 1M, de l'hydroxyde de sodium, ou de l'acide fluorhydrique ou leurs mélanges. Le précurseur d'agent de dissolution de la matrice sol-gel peut être de l'urée ou des composés portant des fonctions amides, notamment du formamide, de l'acétamide, du N-méthylformamide (NMF) et leurs mélanges. De préférence, la concentration en agent de dissolution et/ou en précurseur d'agent de dissolution est telle qu'elle permet la dissolution localisée de la ou des matrices sol-gel de sorte à former des mésopores dans cette ou ces dernières sans dissoudre globalement la ou les matrices sol-gel.

La formation du monolithe poreux peut comporter le vieillissement au moins partiel pour densifier la matrice sol-gel, notamment lorsque le vieillissement n'a pas eu lieu totalement avant.

La formation du monolithe poreux peut comporter un séchage de la matrice sol-gel extraite ou non du moule pour former une matrice sol-gel séchée, après la génération de mésopores le cas échéant. L'étape de séchage peut se faire sous flux d'air ou de gaz inerte, notamment de diazote, argon ou dioxyde de carbone, hélium, voire du dioxygène ou du dihydrogène.

La formation du monolithe poreux peut comporter un traitement thermique de la ou des matrices sol-gel extraites ou non du ou de chaque moule, notamment après le séchage. Le traitement thermique peut se faire dans un contenant fermé sous flux d'air ou de gaz inerte, notamment de diazote, argon ou dioxyde de carbone, hélium, voire du dioxygène ou du dihydrogène et par chauffage progressif suivi du maintien de la température finale pendant un temps prédéterminé. Le chauffage progressif peut être une augmentation de 0,5°C/min jusqu'à atteindre une température supérieure ou égale à 300°C, mieux supérieure ou égale à 340°C, par exemple sensiblement égale à 350°C, pour obtenir un monolithe poreux. La température finale peut être maintenue pendant plus de 1h. Ceci permet de stabiliser la structure du monolithe et d'éliminer les résidus organiques issus de la synthèse.

En variante, le monolithe poreux est formé directement dans un moule dans lequel le sol est inséré et est extrait de ce dernier, notamment par la méthode mentionnée précédemment.

Le procédé peut comporter des modifications du monolithe poreux post fabrication, notamment la fonctionnalisation de la surface du monolithe poreux, notamment avant ou après son dépôt sur le support, notamment après extraction de l'encre et/ou de l'agent protecteur. La surface du monolithe poreux peut être recouverte de molécules tels que décrites précédemment.

### Encre

L'encre et/ou l'agent protecteur peuvent être choisis parmi :
- les glycols linéaires dont la formule brute générique est C₂ₙ H₄ₙ₊₂O₂ où n est un nombre entier positif supérieur ou égal à 1, de préférence tel que n = 3, 4 ou 5 ;
- le cyclohexanediol ;
- le biphényl ;
- le tri(cyclohexyl)méthane ;
- les alcools de formule brute CₙH₂ₙ₊₂O où n est un nombre entier positif supérieur ou égal à 1, de préférence tel que n = 10, 11 ou 12 ;
et leurs mélanges.

L'encre et/ou l'agent protecteur peuvent présenter une viscosité inférieure ou égale à 30 mPa.s⁻¹, notamment dans le cas de l'impression par jet d'encre, mesurée à une pression de 1013,25 hPa, à une température de 22 C et à un taux de cisaillement de 1 s⁻¹ La viscosité peut être mesurée à l'aide d'un viscosimètre cône/plan, notamment à l'aide d'un rhéomètre Anton Paar, modèle Physica MCR 30 ou un dispositif analogue.

De préférence, l'agent protecteur présente un caractère mouillant vis-à-vis du matériau de l'élément solide. Ceci permet un remplissage de l'élément solide poreux par spontané par contact par simple capillarité. Par *« mouillant »,* on comprend qu'une goutte disposée sur le matériau de l'élément solide présente un angle de contact inférieur à 90°, mieux inférieur ou égal à 45°.

En variante, l'agent protecteur présente un caractère non-mouillant vis-à-vis du matériau de l'élément solide, c'est-à-dire qu'une goutte disposée sur le matériau de l'élément solide présente un angle de contact supérieur à 90°. Dans ce cas, le procédé peut comporter l'application d'une surpression lors de l'application de l'agent protecteur sur l'élément solide poreux pour contrebalancer la pression de Laplace, notamment d'une surpression qui est fonction de la taille des pores et de la tension de surface, notamment comprise entre 1 mbar et 1 bar.

### Dispositif

Le dispositif comporte une entrée de fluide et/ou une sortie de fluide, le chemin de circulation fluidique s'étendant de l'entrée de fluide à la sortie de fluide dans le dispositif. De préférence, l'entrée de fluide et la sortie de fluide sont distinctes. L'entrée et/ou la sortie de fluide peut comporter un piquage dans l'épaisseur du polymère relié fluidiquement au circuit fluidique. En variante, l'entrée et/ou la sortie de fluide est formée par le circuit fluidique et/ou l'élément solide, notamment le circuit fluidique et/ou l'élément solide débouchant hors du polymère

Le dispositif peut comporter plusieurs éléments solides poreux ou reliés fluidiquement entre eux en série ou en parallèle par une ou plusieurs portions du circuit fluidique. De préférence, ils sont reliés entre eux en série. Les éléments solides peuvent être sensiblement de même dimensions, structure et/ou porosité ou en variante être différent par une de leur propriété, notamment leur dimension, structure et/ou porosité.

Le dispositif peut former une unité fonctionnelle comportant un module fonctionnel, une entrée et une sortie de fluide du dispositif. L'unité fonctionnelle est configurée pour être relié en série par son entrée et/ou sa sortie de fluide à une ou plusieurs unités fluidique annexes pour former une structure de circulation fluidique complexe. La ou les unités fluidiques annexes peuvent être identiques ou, de préférence, différentes, au moins par leur fonction.

### Brève description des dessins

[Fig 1] représente les différentes étapes du procédé de fabrication selon l'invention,
[Fig 2] représente schématiquement une variante de dispositif de circulation fluidique,
[Fig 3] représente schématiquement une variante de dispositif de circulation fluidique,
[Fig 4] représente schématiquement une variante de dispositif de circulation fluidique,
[Fig 5] représente schématiquement en coupe une variante d'un détail pris au niveau de l'élément solide de dispositif de circulation fluidique,
[Fig 6] représente schématiquement en coupe une variante d'un détail pris au niveau de l'élément solide de dispositif de circulation fluidique,
[Fig 7] représente schématiquement en coupe une variante d'un détail pris au niveau de l'élément solide de dispositif de circulation fluidique,
[Fig 8] représente schématiquement en coupe une variante d'un détail pris au niveau de l'élément solide de dispositif de circulation fluidique,

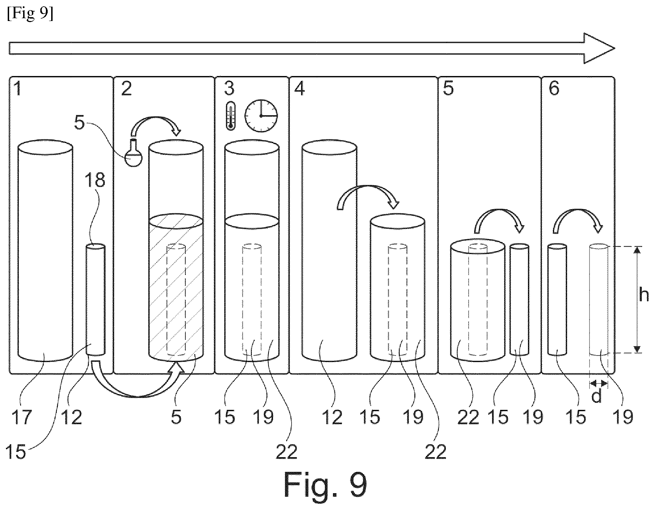

[Fig 9] représente schématiquement un procédé de fabrication d'un monolithe poreux, et
[Fig 10] représente schématiquement une variante de procédé de fabrication d'un dispositif circulation d'un fluide sur un chemin de circulation fluidique.

### Description détaillée

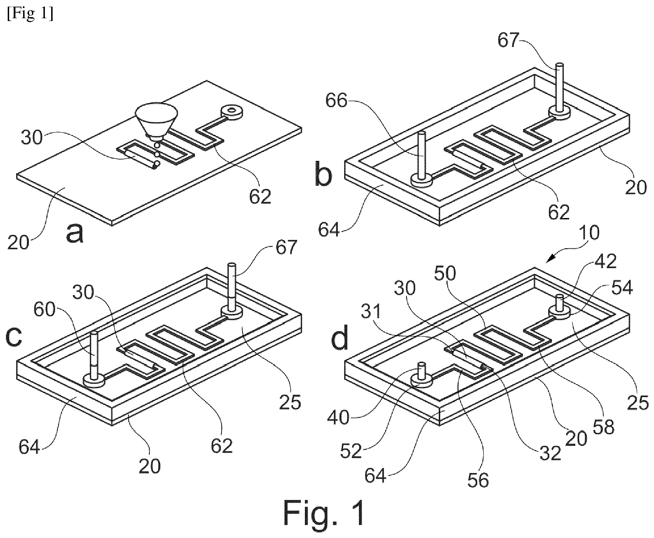

On a illustré à la figure 1 le procédé de fabrication d'un dispositif 10 de circulation d'un fluide sur un chemin de circulation fluidique.

Le dispositif à obtenir, illustré à l'étape d. de la figure 1 comporte un substrat rigide 20, par exemple en verre ou plastique, sur lequel s'étend une couche 25 en un polymère réticulé.

La couche 25 présente en son sein un élément solide poreux ou creux 30 relié à deux entrée/sortie 40 et 42 par un circuit fluidique 50. De préférence, l'élément solide 30 est cylindrique et est reliés aux entrée/sortie par ses deux extrémités opposées 31 et 32 formant des points d'entrée et sortie du chemin de circulation fluidique au travers de l'élément solide 30 de sorte qu'un fluide circulant dans le dispositif traverse de part en part l'élément solide 30 sur toute sa longueur.

Les deux entrée/sortie 40 et 42 peuvent former des conduits fluidiques verticaux au travers de la couche polymère 25, par exemple en PDMS, pour relier fluidiquement l'extérieur du dispositif au circuit fluidique 50 s'étendant au sein de la couche polymère 25, notamment à la jonction entre le substrat 20 et la couche polymère 25. Le circuit fluidique 50 comporte deux chambres 52 et 54 dans lesquelles débouchent les deux sortie/entrée 40 et 42, et deux canaux 56 et 58 reliant les chambres 52 et 54 à l'élément solide 30. Les différents éléments ouverts du dispositif permettent la circulation d'un fluide entre les deux entrée/sortie 40 et 42 au travers du circuit fluidique 50 et de l'élément solide 30.

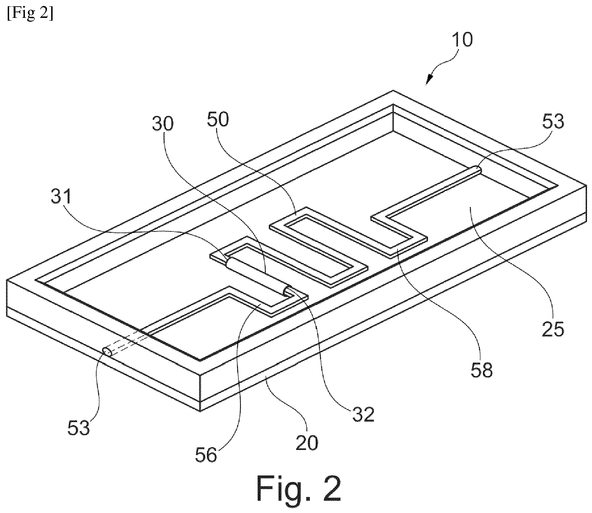

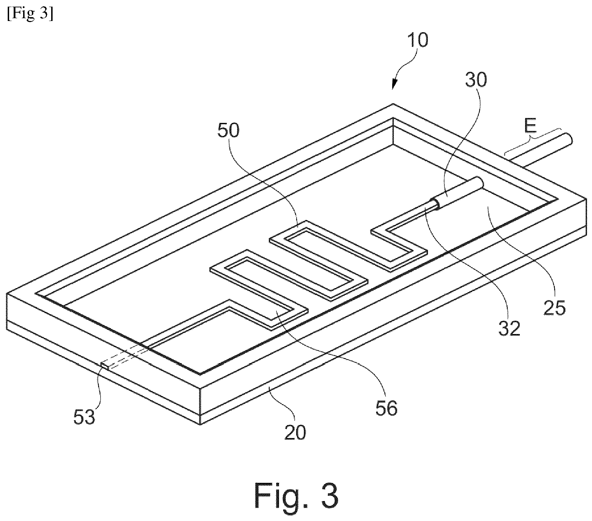

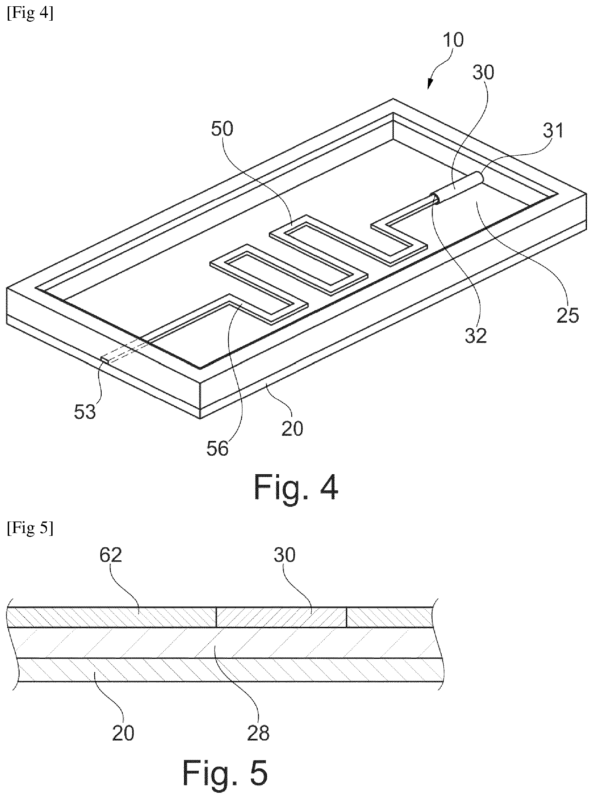

Mais il pourrait en être autrement, au moins une des deux entrée/sortie 40 et 42, mieux les deux entrée/sortie, pourrait s'étendre latéralement de la couche en polymère 25 et être formée par une extrémité 53 et 55 du circuit fluidique 50 débouchant sur une surface latérale de la couche en polymère 25, comme cela est illustré sur la figure 2, ou par une partie E l'élément solide 30 s'étendant au travers d'une surface de la couche en polymère 25, comme illustré sur la figure 3, ou affleurant en surface de la couche en polymère 25, comme illustré sur la figure 4. En variante (non illustré) le dispositif pourrait ne comporter qu'une entrée reliée fluidiquement au circuit fluidique 50 et être dépourvue de sortie. Le circuit fluidique peut former une boucle.

Dans l'exemple illustré sur la figure 1, le circuit fluidique 50 et l'élément solide 30 sont agencés à l'interface entre le substrat 20 et la couche en polymère 25.

Cependant il pourrait en être autrement et le circuit fluidique 50 et/ou l'élément solide 30 pourraient être agencés au sein de la couche polymère 25, le dispositif comportant ou non le substrat rigide 20.

Le dispositif peut comporter plusieurs éléments solides poreux ou creux intégrés au sein de la couche en polymère 25.

De préférence, le chemin de circulation fluidique dans le dispositif est plan dans un plan parallèle à la surface du substrat 20. En variante, le circuit fluidique peut présenter une structure en trois dimensions de sorte que le chemin de circulation fluidique dans le polymère est également en trois dimensions.

L'élément solide peut être un tube ou un capillaire creux. En variante, il peut être un monolithe poreux à porosité simple ou hiérarchique. Dans ce cas, il est de préférence fabriqué par un procédé sol-gel tel que décrit ci- dessous.

Le dispositif peut former une unité fonctionnelle qui peut être reliée à un système de plus grande envergure, notamment à d'autres unités fonctionnelles différentes ou identiques, comportant ou non un élément solide poreux ou creux.

Il est important d'avoir une intégration de l'élément solide dans le dispositif configuré pour que l'élément solide conserve son intégrité et ses propriétés, notamment de porosité dans le cas d'un élément poreux et de circulation du fluide en son sein, et pour que la circulation du fluide dans le dispositif se fasse le long d'un chemin de circulation fluidique passant au sein de l'élément solide et non autour de ce dernier. Il est également important que la connexion entre l'élément solide 30 et le circuit fluidique permette la bonne circulation du fluide entre les deux. La problématique est importante quel que soit l'élément solide poreux ou creux du fait de la présence au sein de la couche en polymère d'une jonction fluidique entre l'élément solide et le circuit fluidique qui pourrait être empêchée par le polymère durant la fabrication et/ou d'une interface entre la couche en polymère et une surface au moins partiellement ouverte de l'élément solide qui pourrait permettre la pénétration du polymère dans l'élément poreux au cours de la fabrication et ainsi empêcher la circulation du fluide dans l'élément solide. Cette problématique est d'autant plus importante dans le cas d'un élément solide poreux autoporté intégré dans le dispositif sans gaine de protection du fait de la présence de pores qui débouchent sur toute sa surface et permettent la pénétration du polymère lors de la formation de la couche polymère.

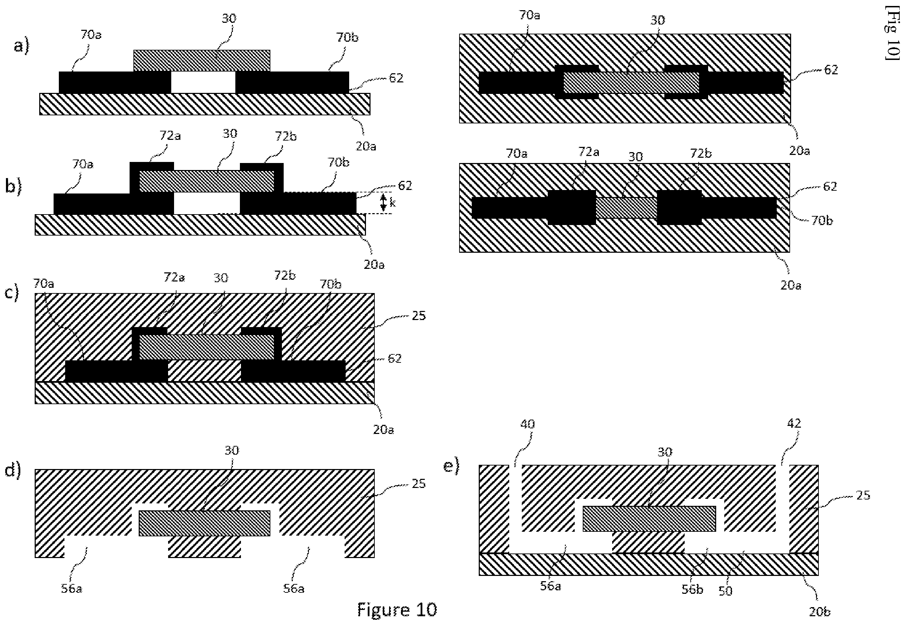

Pour former le dispositif décrit, le procédé comporte à l'étape a. illustrée sur la figure 1, la disposition de l'élément solide poreux ou creux 30 sur la surface plane supérieure d'un support constitué du substrat 20 à une position prédéterminée, puis l'impression sur le support de la trace 62 du circuit fluidique, y compris les chambres fluidiques 52 et 54, avec une encre qui peut être choisie parmi les glycols linéaires dont la formule brute générique est C₂ₙ H₄ₙ⁺²O₂ où n est un nombre entier positif supérieur ou égal à 1, de préférence tel que n = 3, 4 ou 5, le cyclohexanediol, le biphényl, le tri(cyclohexyl)méthane ou les alcools de formule brute CₙH₂ⁿ⁺²O où n est un nombre entier positif supérieur ou égal à 1, de préférence tel que n = 10, 11 ou 12. En variante, l'impression de la trace 62 du circuit fluidique se fait avant le positionnement de l'élément solide 30 sur le support. La trace 62 est imprimée et l'élément solide 30 est disposé de sorte que, à la jonction entre l'élément solide 30 et l'encre, l'encre et l'élément solide 30 soient au contact, ici aux deux extrémités 31 et 32 de l'élément solide 30. L'encre peut pénétrer dans l'élément solide 30 pour le remplir s'il n'est pas rempli préalablement par un liquide protecteur ou en surface au niveau de la jonction sur une certaine distance. Un tel contact/pénétration permet d'empêcher qu'il y ait du polymère qui s'immisce à la jonction entre les deux, ce qui empêcherait la circulation fluidique ultérieurement. En variante encore, l'impression de la trace 62 du circuit fluidique se fait en plusieurs étapes, une première impression ayant lieu avant le positionnement de l'élément solide 30 sur le support et une deuxième impression après, comme cela est illustré sur la figure 10. Cela peut permettre d'avoir une bonne jonction entre la trace et l'élément solide et de positionner l'élément solide sur une ou plusieurs couches d'encre avant la deuxième impression.

L'impression peut se faire par jet d'encre, au moyen d'une buse d'impression et d'une encre liquide dont la viscosité est inférieure ou égale à 30 mPa.s⁻¹. La distance entre d'une part, ladite buse d'impression et d'autre part, le support peut être comprise entre 0,5 mm et 20 mm. La taille d'une goutte d'encre éjectée par ladite buse d'impression peut être comprise entre 10 µm et 100µm. La fréquence d'éjection des gouttes d'encre de ladite buse peut être comprise entre 50Hz et 5kHz. Le support d'une part et ladite buse d'impression d'autre part, peuvent être adaptés pour autoriser un déplacement relatif de l'un par rapport à l'autre avec une vitesse de déplacement relative contrôlée, comprise entre 1 mm/s et 100 mm/s. En variante, l'impression de l'encre s'effectue au moyen d'une seringue. La distance entre d'une part, une extrémité de la seringue par laquelle l'encre est dispensée et d'autre part, le support peut être comprise entre 0,1mm et 1mm. Le débit d'encre dispensé par l'extrémité de ladite seringue peut être compris entre 0,01 nl/s et 10 nl/s. Le support d'une part et, ladite extrémité de seringue d'autre part, peut être adaptés pour autoriser un déplacement relatif de l'un par rapport à l'autre avec une vitesse de déplacement relative contrôlée, comprise entre 0,1 mm/s et 10 mm/s.

Selon l'épaisseur de la trace 62 du circuit fluidique et/ou sa structure dans le polymère, il peut être nécessaire de superposer au moins à certains endroits plusieurs couches d'encre après séchage ou solidification de chaque couche. Cela peut permettre notamment de réaliser une structure en trois dimensions de la trace 62.

L'encre est ensuite laissée à sécher ou solidifier, soit spontanément au vu de sa nature, soit par chauffage ou refroidissement.

Optionnellement, un recuit de l'encre peut être effectué à une température inférieure à la température d'extraction de l'encre à pression équivalente. Un tel recuit permet de diminuer la rugosité de la trace déposée. En effet, une fois l'encre solidifié et malgré le soin apporté aux conditions de dépôt, on peut constater que la surface de l'encre, sous forme solide, peut présenter une rugosité significative. En conséquence, cette rugosité pourra se retrouver sur les parois polymère du circuit fluidique. La rugosité peut avoir un effet non négligeable sur les conditions d'écoulement dans le dispositif et par suite, générer des pertes de charges et/ou des échanges thermiques indésirables ou modifier les conditions d'analyse selon l'architecture du dispositif.

Après séchage ou solidification de l'encre et optionnellement recuit, le procédé comporte, comme illustré à l'étape b. de la figure 1, le positionnement d'un moule 64 sur le substrat pour permettre le moulage du polymère sur le circuit fluidique 20 et l'élément solide 30. Le procédé peut également comporter le positionnement d'éléments additionnels, ici des tubes 66 et 67 pour former les deux entrée/sortie 40, 42 dans l'épaisseur du polymère.

Le polymère à l'état liquide 25 est ensuite coulé, comme illustré à l'étape c. de la figure 1, dans le moule pour recouvrir l'encre formant la trace 50 du circuit fluidique et l'élément solide 30. Il est ensuite solidifié par réticulation. La réticulation peut être facilité par un agent de réticulation ou un photo-initiateur présent dans le polymère. En variante, le polymère peut comporter un solvant, le polymère réticulant après évaporation du solvant. La réticulation peut se faire par chauffage à une température inférieure à la température d'extraction de l'encre à pression égale. Le polymère 25 est tel qu'il n'est pas miscible avec l'encre.

Enfin à l'étape d. de la figure 1, l'encre est extraite du polymère 25 par passage en phase vapeur, notamment par sublimation ou par liquéfaction puis vaporisation, en chauffant le dispositif et/ou en soumettant le dispositif à un différentiel de pression. Les éventuels éléments additionnels amovibles, notamment les tubes d'entrée/sortie 40 et 42 sont retirés avant ou après extraction de l'encre.

Le dispositif est ensuite lavé par passage d'un liquide dans le dispositif de l'entrée à la sortie.

Cependant, l'invention n'est pas limitée à une telle méthode d'extraction. D'autres méthodes sont envisageables, notamment le retrait du support pour mettre à nu l'encre dans le polymère et la dissolution de l'encre par un solvant, notamment de l'alcool, et/ou la vaporisation ou sublimation des résidus d'encre avant de replacer un support identique ou différent.

L'extraction de l'encre après réticulation permet la formation du circuit fluidique 50 dans le polymère 25.

Le moule 64 peut être conservé ou retiré après solidification.

Dans le cas d'un élément solide 30 creux, les extrémités creuses de l'élément solide peuvent être recouverte par l'encre de sorte que le polymère 25 ne peut pas pénétrer dans l'élément solide 30 creux. Dans ce cas, l'épaisseur de l'encre est supérieure ou sensiblement égale à la hauteur de l'élément solide 30. En variante, le creux de l'élément solide peut être bouché en entrée et/ou sortie ou rempli par un agent de protection, notamment identique ou différent de l'encre d'impression, avant que l'élément creux ne soit disposé sur le support. Ce dernier peut être extrait en même temps que l'encre par la même méthode. Dans ce cas, peu importe l'épaisseur de l'encre, elle peut par exemple être inférieure à la hauteur de l'élément solide, le creux étant protégé de la pénétration du polymère.

Dans le cas d'un élément solide 30 poreux, l'élément solide 30 peut être recouvert sur toute sa surface ou rempli au moins sur le chemin de circulation fluidique d'un agent de protection, notamment identique ou différent de l'encre d'impression, avant d'être disposé sur le support pour empêcher le polymère de rentrer dans l'élément. Ce dernier peut être extrait en même temps que l'encre par la même méthode. En variante, la réticulation du polymère 25 est réalisée suffisamment rapidement pour empêcher le polymère 25 de boucher l'élément solide en toute section par laquelle le chemin de circulation fluidique passe, ceci afin de s'assurer de la circulation fluidique possible au sein de l'élément solide 30.

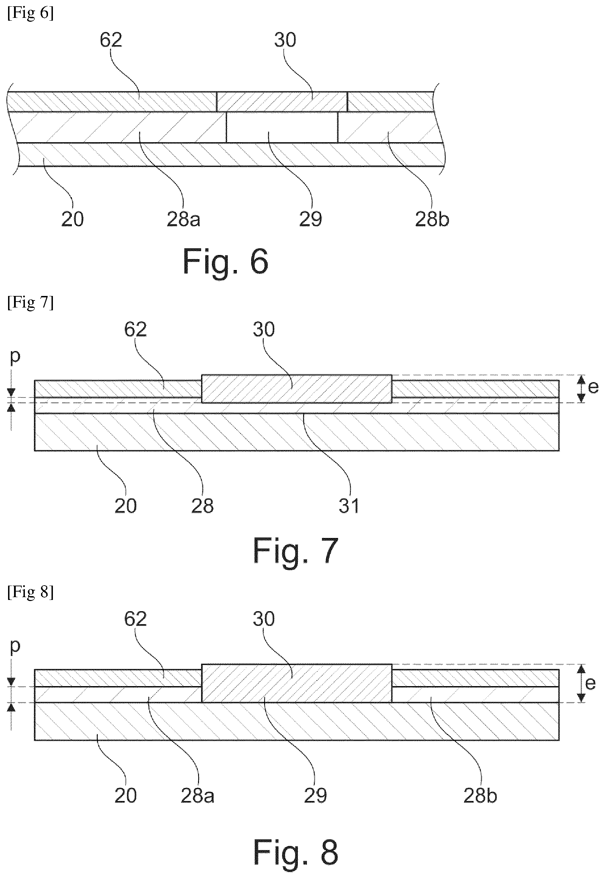

En variante, le support peut comporter sur le substrat 20 un ou plusieurs éléments de support ou de réception 28 déposés sur le substrat. Le ou les éléments peuvent être en un polymère réticulé de surface externe plane, notamment en un polymère identique à celui de la couche en polymère 25. Le support peut comporter un élément de support 28 formant une couche support pour l'impression et le dépôt de l'élément solide 30, comme illustré sur le détail en coupe des figures 5 et 7. Une telle couche de support peut être déposée sur le substrat 20 ou être formée directement sur le substrat par coulage dans une moule sur ce dernier et réticulation. La couche support 28 peut former une surface plane, comme illustré sur la figure 5 ou présenter un ou plusieurs reliefs en surface, notamment une cavité 31 de réception de l'élément solide 30, comme illustré sur la figure 7. Dans ce dernier cas, la cavité 31 de réception de l'élément solide 30 présente une profondeur p inférieure à 50% de la dimension e de l'élément solide 30 dans la direction de la profondeur de la cavité. En variante illustré sur les figures 6 et 8, le support comporte plusieurs éléments de support ou de réception 28a et 28b disposées sur le substrat 20 et espacées entre elles d'une distance non nulle pour former une cavité 29. Comme illustré sur la figure 6, l'élément solide 30 peut être déposé à cheval sur les deux éléments de support 28a et 28b espacés entre eux d'une distance d inférieure à la longueur L de l'élément solide 30, la trace 62 du circuit fluidique étant imprimé sur les éléments de support 28a et 28b. Dans ce mode de réalisation, lors du coulage du polymère 25, ce dernier vient entourer l'élément solide 30 dans la cavité 29 libre entre les deux éléments de support 28a et 28b. De la sorte, l'élément solide 30 se retrouve encapsulé dans une couche polymère monolithique, ce qui réduit le risque de cassure à la jonction avec le substrat 20 lorsque le substrat 20 est retiré, notamment dans le cas d'un élément solide 30 de grande dimension transversale. En variante illustré sur la figure 8, l'élément solide 30 est reçu dans la cavité formée entre les éléments de réception 28a et 28b, la cavité étant d'une profondeur p inférieure à la dimension de l'élément solide dans la direction de la profondeur de la cavité. De préférence, elle vient au contact des éléments de réception 28a et 28b dans la cavité 29 par ses deux extrémités longitudinales de sorte que l'encre déposée sur les éléments de réception soit en contact avec l'élément solide 30.

Le substrat 20 peut être retiré après extraction de l'encre, en particulier dans le cas où le circuit fluidique 50 et l'élément solide 30 ne sont pas au contact du substrat 20, notamment du fait de la présence du ou des éléments de support 28.

Dans les exemples illustrés, le circuit fluidique est surtout composé de canaux. Il va sans dire que le circuit peut présenter toute structure compatible avec le procédé de fabrication avec l'impression de l'encre. Il peut notamment comporter une ou des chambres fluidiques ou intégrer des éléments complémentaires solides autres que l'élément solide, notamment des éléments de connectique pour permettre la circulation du fluide dans le circuit fluidique, notamment pour connecter le circuit fluidique à l'entrée ou la sortie de fluide ou pour relier le dispositif à un autre dispositif identique ou différent, et/ou des éléments d'agencement de l'élément solide sur le support, notamment de cales disposées sous l'élément solide, et/ou des éléments de fonctionnalisation du circuit fluidique, notamment des billes fonctionnalisées ou non s'étendant dans une portion du circuit fluidique,. Ces éléments complémentaires peuvent rester dans le circuit fluidique final ou ne servir que durant la fabrication pour la formation de canaux par exemple.

Dans l'exemple illustré, le remplissage par le polymère et sa réticulation se fait en une fois. Cette étape pourrait être réalisée en plusieurs étapes de remplissage partiel et réticulation successives.

On a illustré à la figure 7 les différentes étapes d'un exemple de procédé de fabrication du monolithe poreux.

Le procédé comporte une première étape non illustrée de formation d'une solution aqueuse d'un agent porogène et d'un précurseur sol-gel et d'éventuels additifs, notamment un acide et/ou un agent de dissolution de la matrice.

L'agent porogène peut être choisi parmi les polymère soluble dans l'eau, notamment le polyéthylène glycol (PEG), le poly(acide acrylique), l'acide poly(styrène sulfonate) de sodium, le poly(éthylène imine).

Le ou les polymères solubles dans l'eau peuvent présenter un poids moléculaire compris entre 1 000 et 100 000 Dalton, de préférence entre 5 000 et 50 000 Dalton, encore mieux entre 5 000 et 30 000 Dalton.

La concentration en agent porogène, notamment en PEG, peut être comprise entre 0,015 g et 0,35 g par ml de sol, préférentiellement entre 0,02 et 0,2 g par ml de sol. Ces valeurs sont reliées à la concentration de précurseur sol-gel, notamment de tétraméthoxysilanes (TMOS), selon des valeurs de 0,03 à 1 g d'agent porogène, notamment de PEG par ml de précurseur sol-gel, notamment de tétraméthoxysilanes (TMOS), préférentiellement selon des valeurs de 0,06 à 0,6 g d'agent porogène, notamment de PEG par ml de précurseur sol-gel, notamment de tétraméthoxysilanes (TMOS). Elle est choisie en fonction de la taille des macropores voulue pour le monolithe poreux final.

Le précurseur sol-gel peut être choisi parmi les alcoxydes, notamment les organométalliques hydrolysable et condensables, notamment les alcoxydes de zirconium, notamment le butoxyde de zirconium (TBOZ), le propoxide de zirconium (TPOZ) les alcoxydes de titane, de niobium, de vanadium, d'yttrium, de cérium, d'aluminium ou de silicium, notamment le tétraméthoxysilane (TMOS), le tétraéthoxysilane (TEOS), le tétrapropoxysilane (TPOS), le tétrabutoxysilane (TBOS), les triméthoxysilane, notamment le méthyltriméthoxysilane (MTMOS), le propyltriméthoxysilane (PTMOS,) et l'éthyltriméthoxysilane (ETMOS), les triéthoxysilanes, notamment le méthyltriéthoxysilane (MTEOS), l'éthyltriéthoxysilane (ETEOS), le propyltriéthoxysilane (PTEOS), l'aminopropyltriethoxysilane (APTES) et leurs mélanges, par exemple le TMOS. Il est aussi possible d'utiliser des précurseurs tels que les silicates de sodium, ou les colloïdes de titanes, notamment si les exigences de pureté le permettent, c'est à dire ne sont pas trop élevées.

La proportion d'agent porogène dans le sol et la proportion de précurseur sol-gel dans le sol sont prédéterminées en fonction des caractéristiques, notamment la porosité totale et la taille moyenne des macropores, d'un échantillonnage de matrices sol-gel connues pris juste après gélification.

La solution est ensuite agitée pendant une durée prédéterminée comprise entre 5 min et 3h, encore mieux comprise entre 15 min et 2h, à une température contrôlée sensiblement constante comprise entre 0°C et 90°C, mieux entre 0°C et 50°C. Cette étape d'agitation permet d'initier le procédé sol gel pour former un sol 5 avant la séparation de phase.

Le sol 5 est alors ajouté dans l'étape 2 dans un récipient 12 pour remplir au moins partiellement ledit récipient 12 et au moins un moule 15 contenu dans l'enceinte 12.

Le moule 15 peut être positionné dans l'enceinte que l'on remplit progressivement avec le sol 15 de telle manière à ce que le moule 15 se remplisse progressivement sans présence de bulle d'air ou de gradient de composition chimique. Le remplissage peut se faire jusqu'à immersion totale du moule 15. L'immersion partielle est aussi possible. L'ajout du moule dans le sol 5 contenu dans l'enceinte 12 est aussi possible.

L'enceinte 12 peut être configurée pour contenir une pluralité de moules 15 identique ou non. L'enceinte 12 peut être cylindrique comme illustré ou avoir une tout autre forme. L'enceinte 12 peut être en plastique, notamment en PTFE, PP, PE, PC, PET, PVC, ou verre ou inox.

Le ou les moules 15 comportent deux ouvertures 17 et 18 sur des surfaces opposées du moule 15, l'une au moins des deux ouvertures 17 s'étendant sous le niveau de sol après remplissage. De telles ouvertures permettent le remplissage du ou des moules 15 par remplissage de l'enceinte 12 contenant le ou les moules 15 ou par immersion au moins partielle du ou des moules 15 dans le sol 5 contenu dans l'enceinte 12 et la circulation du sol 5 entre l'intérieur et l'extérieur du ou des moules avant condensation totale de ce dernier. Dans l'exemple illustré, le ou les moules 15 sont sous forme de tubes ouverts à leurs deux extrémités et s'étendent verticalement dans l'enceinte 12, mais il pourrait en être tout autrement, le tube pourrait être orienté dans l'enceinte différemment et/ou le moule pourrait avoir une autre forme.

Le ou les moules 15 peuvent être entièrement contenus dans l'enceinte 12, comme cela est illustré, ou dépasser de ce dernier. Dans le premier cas, le ou les moules 15 peuvent être immergés entièrement ou non dans le sol 5 après remplissage.

Le ou les moules 15 peuvent être en plastique, notamment en PTFE, PEEK, FEP, PE, PP, ou acide polylactique ou en verre ou en inox, notamment en silice fondue ou borosilicate.

Le ou les moules peuvent être en un corps poreux.

Le ou les moules peuvent être formés par impression 3D ou par moulage.

La plus grande dimension transversale de la cavité du ou des moules 15, notamment le diamètre d de cette cavité, peut être compris entre 13 mm et 0,025 mm.

Une fois le sol 5 introduit dans l'enceinte 12 et le ou les moules 15, la condensation est réalisée en étape 3 dans l'ensemble de l'enceinte et du moule. Cette transition sol-gel peut être suivi d'une maturation (ou vieillissement) au moins partielle de l'ensemble. Cette étape permet d'assurer la formation de macropores homogènes de nature similaire dans la matrice sol-gel formé 22, et cela quelle que soit sa forme et sa taille.

Pendant la condensation, la température peut être maintenue sensiblement constante, notamment entre 15° et 90°C, préférentiellement 25 et 70°C, pendant une durée comprise entre 10 min et 4h. La durée de la condensation et la température prédéterminée dépendent de la structure interne de la matrice sol-gel recherchée et de la durée de l'agitation de la solution initiale dans l'étape de formation du sol.

Le vieillissement au moins partiel peut durer entre 30 min et 2 semaines, notamment moins de 72h à température ambiante. De préférence, la durée de vieillissement est suffisamment faible pour éviter la formation de mésopores et/ou micropores.

Un bloc 22 de matrice sol-gel contenant le moule 15 est alors extraite de l'enceinte 12 à l'étape 4. Dans le cas où le moule 15 n'est que partiellement immergé, cette étape peut être facultative comme nous le verrons par la suite.

Le moule 15 avec la matrice sol-gel 15 qu'il contient est ensuite extrait du solide poreux à l'étape 5, par exemple coupant à fleur de moule la matrice sol-gel du bloc 22 puis en retirant le moule 15 avec la matrice sol-gel 19 qu'il contient, ou bien en cassant la matrice sol-gel du bloc 22 autour du moule 15. Dans le cas où l'immersion était partielle, il est possible de retirer directement le moule 15 avec la matrice sol-gel 19 qu'il contient du bloc préalablement extrait ou directement de l'enceinte 12.

De façon optionnelle, la matrice sol gel 19 est extraite du moule 15 à l'étape 6 pour obtenir un monolithe autoporté. Ceci est réalisé au moyen d'une pression contrôlée exercée sur la matrice sol-gel 19 tout en en maintenant le moule 15. La pression peut être obtenue soit avec un solide en plastique, en verre, tel qu'un capillaire en silice fondue par exemple, ou tout autre matière assez robuste et de dimension inférieure au moule 15, soit avec un gaz à débit contrôlé. L'opération d'extraction peut être facilitée par immersion de l'ensemble moule 15 et matrice sol-gel 19 dans un liquide. Il est éventuellement possible de générer une légère différence de pression en tapotant gentiment l'ensemble moule 15 et matrice sol-gel 19 pour extraire la matrice sol-gel 19.

Puis, le procédé peut comporter une étape de génération contrôlée de la mésoporosité. Cette étape peut se faire par immersion de la matrice sol-gel 19 ou de l'ensemble moule-matrice sol-gel dans une solution basique, par exemple une solution d'hydroxyde d'ammonium 1M, soit par chauffage du matériau dans de l'eau en présence d'un précurseur, par exemple de l'urée pour générer de l'ammoniac *in situ.* A noter que dans la deuxième méthode, il est possible de rajouter de l'hydroxyde d'ammonium. Cette opération peut durer dure entre 0,5h et 50h à une température prédéterminée sensiblement constante de la matrice sol-gel comprise entre 30°C et 150°C. Cette étape peut être faite sur plusieurs matrices sol-gel simultanément, i.e. dans un même bain, issus d'un même bloc ou non.

De préférence, la taille des pores obtenue est inférieure ou égale à 50 nm, mieux comprise entre 2 et 50 nm.

La matrice sol-gel obtenues est ensuite séchée. Pour ce faire, elle est placée dans un contenant fermé, notamment un autoclave, pour être séchée en condition critique ou supercritique, notamment sous flux d'air ou de gaz inerte, notamment du diazote (N₂) pour une durée comprise entre 10 et 20h. Ils sont ensuite soumis à une rampe de 0.5°C/min jusqu'à 350°C avec un palier de quelques heures à cette dernière température et sous flux de gaz inerte (d'autres gaz peuvent être employés).

On obtient alors un monolithe autoporté ou intégré dans un moule, notamment un capillaire, prêt à l'emploi.

Le monolithe poreux obtenu comporte de préférence des macropores, i.e. présentant une dimension choisie supérieure ou égale à 50 nm, et des mésopores, i.e. présentant une dimension choisie comprise entre 2 et 50 nm.

Il est préférentiellement de structure sensiblement homogène dans tous son volume.

Le ou les monolithes poreux peuvent présenter un rapport de forme, définie comme sa hauteur sur sa plus grande dimension transversale, compris entre 0,2 et 100.

Le procédé peut comporter des modifications du monolithe poreux post fabrication, notamment la fonctionnalisation des surfaces interne du monolithe poreux. La fonctionnalisation pourra être réalisée selon des procédés en phase liquide ou bien en phase gaz, utilisant des organo-silanes, notamment des chlorosilanes (e.g. octadecyltrichlorosilane) et les alkoxysilanes (octadecyltriethoxysilane, aminopropyltriethoxysilane, propyltriméthoxysilane), ou bien encore l'hexadimethylsilazane.

En variante, le ou les moules peuvent n'avoir qu'une ouverture. Cette dernière s'ouvre dans le sol après remplissage pour permettre la circulation du sol entre le moule et l'enceinte.

En variante, la solution initiale peut être une émulsion ou une solution de matriçage (« templating ») contenant des précurseurs sol-gel.

### Exemple 1

Dans cet exemple, un monolithe poreux autoporté de forme cylindrique de 700 µm de diamètre environ et de longueur de 15 mm environ, ayant des macropores d'environ 2 µm et des mésopores d'environ 15 nm est intégré dans un dispositif microfluidique au centre d'un canal de circulation fluidique droit de quelques centaines de micromètres de diamètre comme illustré sur la figure 7.

Le monolithe poreux a été fabriqué par un procédé sol-gel décrit ci-dessous.

Une solution est préparée en mélangeant 0,33 g de PEG avec 2 mL de TMOS dans 4 mL d'acide acétique 0,01 M. La solution est agitée à 0°C pendant 30 min pour former un sol puis transférée dans un récipient en polypropylène (PP) dans lesquels un tube en PTFE d'environ 1 mm de diamètre a été préalablement positionné verticalement. Le remplissage est réalisé en ajoutant progressivement le sol dans l'enceinte à partir du point le plus bas à l'aide d'une micropipette. La quantité de solution ajoutée est telle que le moule est totalement immergé.

L'enceinte est placée à une température de 40°C, et la gélification se produit entre 45 et 50 min après le transfert dans l'enceinte. Après que la gélification a eu lieu, le gel est laissé à vieillir pendant 24h à 40°C. Puis, la matrice sol-gel issue de la gélification et de la maturation est extraite de l'enceinte et cassée avec une pince métallique pour récupérer le moule qui y a été incorporés. On extrait ensuite la matrice sol-gel monolithique encapsulée dans le moule à l'aide d'une pression manuelle exercée par un tube d'un diamètre inférieur 1 mm. Pour ce protocole, cette pression par un tube solide est suffisante pour réaliser l'extraction du monolithe et ne fragilise pas le gel.

La matrice sol-gel obtenue est rapidement immergée dans une solution de NH₄OH 1M, en respectant un rapport d'environ 5 entre les volumes de solution basique et le volume occupé par la matrice sol-gel.

La matrice obtenue est ensuite disposée dans un autoclave. Ce dernier est placé dans un four et connecté par des tubes qui permettent une circulation de gaz. Le gel est alors séché pendant 12H sous N₂. Finalement, un traitement thermique est réalisé avec une rampe de 0.5°C/min jusqu'à 350°C et un palier de 2h à cette dernière température.

Le monolithe poreux autoporté ainsi obtenu est ensuite protégé par immersion pendant environ 1 minute dans du 1,8 octanediol formant une encre d'imprégnation à 80°C. Préférentiellement, le monolithe cylindrique imprégné est mis en contact avec un papier absorbant pour supprimer l'excès de liquide avant d'être placé dans une coupelle en verre jusqu'à solidification du liquide protecteur présent dans le matériau poreux.

Un substrat rectangulaire en polydiméthylsiloxane (PDMS) est fabriqué et disposé sur une lame de verre.

Le monolithe poreux imprégné est ensuite disposé sur le substrat en PDMS. De part et d'autre des extrémités du monolithe poreux, du 1,8 octanediol est imprimé sous la forme d'une trace de deux canaux droits de diamètre inférieur à 0,7 mm de chaque côté du monolithe poreux imprégné et reliés à ce dernier à chacune de ses extrémités, l'encre étant au contact des extrémités du monolithe poreux imprégnée et pouvant se mélanger avec l'encre d'imprégnation. L'impression se fait à l'aide d'une micropipette de faible volume ou bien d'une imprimante.

A chaque extrémité libre des canaux, des trous cylindriques sont formés au travers du substrat de PDMS à l'aide d'un emporte-pièce pour PDMS de 0,5 mm. Ces trous constituent les entrées et sorties du futur dispositif. Les trous sont ensuite recouverts et liés aux extrémités du canal par l'encre précédente. Il est aussi possible de générer ces trous pendant ou après le recouvrement et en utilisant d'autres moyens qu'une encre protectrice (par exemple, ajout d'éléments en PDMS).

Un moule en PDMS rectangulaire ouvert sur les faces du dessus et du dessous et dont les dimensions sont inférieures ou égales à celles du substrat, est ensuite placé sur le substrat pour permettre l'ajout de la couche polymère de recouvrement liquide tout en évitant son étalement.

Du PDMS liquide contenant un réticulant est ensuite ajouté dans le moule de sorte à recouvrir totalement le monolithe et l'encre. Le PDMS est ensuite réticulé à 100°C pendant 2h.

Le dispositif formé est ensuite placé sous vide et chauffé à 100°C de manière à ce que le l'encre présent dans le matériau et formant les canaux de part et d'autre du monolithe poreux, puisse se sublimer et/ou s'évaporer. Pour finir, le dispositif est lavé avec un mélange d'eau/éthanol (50/50) puis avec de l'éthanol pur avant d'être séché dans une étuve à 40°C pendant 24h.

Le dispositif fluidique obtenu permet la circulation de fluide de l'entrée à la sortie en passant par le monolithe poreux.

### Exemple 2

Dans cet exemple, le substrat est en verre et la couche de recouvrement est en PDMS, un monolithe poreux d'un diamètre de 5 mm obtenu par le même procédé sol-gel que décrit dans l'exemple 1, à l'exception de la taille du tube, est déposé sur deux éléments en PDMS formant des éléments de support, eux même posés sur le substrat en verre comme illustré sur la figure 6. L'ajout de PDMS liquide permet alors de former la couche polymère autour du monolithe poreux et assure une bonne étanchéité.

Le procédé est réalisé comme suit.

Le monolithe poreux d'un diamètre 5 mm, ayant des macropores d'environ 2 µm et des mésopores d'environ 15 nm, est protégé par immersion pendant environ 1 minute dans un liquide protecteur de 1,8 octanediol chauffé à 80°C. Préférentiellement, le monolithe cylindrique imprégné est placé et roulé sur un papier absorbant pour supprimer l'excès de liquide avant d'être placé dans une coupelle en verre jusqu'à solidification du liquide protecteur présent dans le matériau poreux.

Une lame de verre est utilisée. Deux carrés de PDMS sont placés sur la lame de verre de sorte que la distance entre les deux carrés soit inférieure à la longueur du monolithe poreux imprégné. Le monolithe poreux est disposé à cheval sur les carrés en PDMS. De part et d'autre des extrémités du matériau, sur les deux éléments en PDMS de support, du 1,8 octanediol est déposé de sorte à former un canal droit de diamètre inférieur à 0,7 mm et relié au monolithe poreux imprégné par contact à ses extrémités. Le dépôt se fait à l'aide d'une micropipette de faible volume ou bien d'une imprimante.

Un moule à base de PDMS rectangulaire ouvert sur les faces du dessus et du dessous et dont les dimensions sont inférieures ou égales à celles du substrat, est placé sur le substrat pour permettre la formation de la couche de recouvrement en polymère liquide tout en évitant son étalement. Du PDMS liquide contenant du réticulant est ensuite ajouté dans le moule de sorte à recouvrir totalement le canal et le monolithe poreux. Le PDMS est ensuite réticulé à 100°C pendant 2h.

Le dispositif contenant encore l'encre est ensuite placé sous vide et chauffé à 100°C de manière à ce que l'encre présent dans le matériau et formant le canal, puisse se sublimer et/ou s'évaporer. Pour finir, le dispositif est lavé avec un mélange d'eau/éthanol (50/50) puis avec de l'éthanol pur avant d'être séché dans une étuve à 40°C pendant 24h.

La lame de verre est retirée puis à l'aide d'un emporte-pièce pour PDMS de 0,5 mm, des trous cylindriques au travers de l'enveloppe de PDMS sont formés sur chaque extrémité du canal droit. Le retrait de la lame de verre peut se faire avant ou après extraction de l'encre.

### Exemple 3

Cet exemple est décrit en relation avec la figure 10 illustrant les différentes étapes décrites ci-dessous.

Dans cet exemple, le substrat est en verre.

Un monolithe poreux d'un diamètre de 800µm obtenu par le même procédé sol-gel que décrit dans l'exemple 1, à l'exception de la taille du tube, est formé. Le monolithe poreux a des macropores d'environ 2 µm et des mésopores d'environ 15 nm, et est protégé par immersion pendant environ 1 minute dans un liquide protecteur de 1,8-octanediol chauffé à 80°C. Préférentiellement, le monolithe cylindrique imprégné est placé et roulé sur un papier absorbant pour supprimer l'excès de liquide avant d'être placé dans une coupelle en verre jusqu'à solidification du liquide protecteur présent dans le matériau poreux.

A l'étape a) illustrée par le dispositif en coupe à gauche et en vue du dessus à droite, une première impression de 1,8 octanediol est réalisée sur un support initial 20a pour former deux portions continues 70a et 70b d'encre disjointes entre elles. L'impression se fait à l'aide d'une micropipette de faible volume ou bien d'une imprimante en une ou plusieurs épaisseurs. Une fois l'encre des deux portions continues 70a et 70b sèche, le monolithe poreux 30 imprégné est déposé sur l'encre des deux portions continues 70a et 70b, chacune de ses extrémités s'étendant sur une des deux portions 70a et 70b de sorte à former un pont entre ces dernières.

A l'étape b) illustrée par le dispositif en coupe à gauche et en vue du dessus à droite, une deuxième impression de 1,8-octanediol est réalisé à la jonction entre le monolithe poreux 30 et l'encre des portions 70a et 70b pour former des portions verticales 72a et 72b respectivement recouvrant les extrémités du monolithe poreux 30.

Le monolithe poreux 30 est alors maintenu par l'encre en ayant ses extrémités encapsulées dans l'encre respectivement de l'association des portions 70a et 72a et des portions 70b et 72b. Il est surélevé par rapport au support initial 20a d'une hauteur k de quelques micromètres à quelques millimètres. La hauteur k peut être sensiblement égale à l'épaisseur de l'encre des portions 70a et 70b. Elle peut être de 200 µm.

A l'étape c) illustrée par le dispositif en coupe, un moule à base de PDMS rectangulaire ouvert sur les faces du dessus et du dessous et dont les dimensions sont inférieures ou égales à celles du substrat, est placé sur le substrat pour permettre la formation de la couche de recouvrement en polymère liquide tout en évitant son étalement. Du PDMS liquide contenant du réticulant est ensuite ajouté dans le moule de sorte à recouvrir totalement la trace 62 formé par l'encre et le monolithe poreux. Le PDMS est ensuite réticulé par chauffage, par exemple à 100°C pendant 2h ou à température ambiante pendant 24h, ou par chauffage à 40°C pendant 2h puis à 100°C pendant 1h. Le PDMS passe sous le monolithe poreux 30 entre les portions 70a et 70b.

A l'étape d) illustrée par le dispositif en coupe, le support initial 20a est retiré et l'encre de la trace 62 de l'ensemble formé de l'encre, du monolithe et du polymère réticulé est dissoute dans l'alcool. L'ensemble est ensuite placé sous vide et chauffé à 100°C de manière que les reste d'encre présent dans le matériau, puisse se sublimer et/ou s'évaporer. Pour finir, le dispositif est lavé avec un mélange d'eau/éthanol (50/50) puis avec de l'éthanol pur avant d'être séché dans une étuve à 40°C pendant 24h. Cela permet de former les microcanaux 56a et 56b du circuit fluidique 50 dans le polymère réticulé 25

A l'étape e) illustrée par le dispositif en coupe, l'ensemble formé du monolithe, du polymère réticulé et des canaux 56a et 56b est fixé sur un nouveau support 20b identique ou différent du support initial 20a de sorte à fermer de façon étanche les canaux 56a et 56b. A l'aide d'un emporte-pièce pour PDMS de 0,5 mm, des trous cylindriques au travers de l'enveloppe de PDMS sont formés sur chaque extrémité des microcanaux 56a et 56b pour former l'entrée 40 et la sortie 42.

Le dispositif obtenu est utilisé pour réaliser une chromatographie, notamment d'adsorption. Le monolithe poreux en tant que phase stationnaire, permet alors de séparer des molécules issues d'un mélange tels que les colorants alimentaires E133 et E129 au moyen d'un gradient de mélange eau/acétonitrile, en tant que phase mobile. Un mélange de deux colorants, le E133 (bleu) et le E129 (rouge), est effectué. 200µl du mélange est inséré dans le circuit fluidique par l'entrée 40 avec un débit de 100µl/min. Le dispositif est observé par le dessus par une caméra. Le canal d'entrée 56a présente la couleur du mélange lorsque le mélange le traverse et le monolithe 30 présente une couleur marron qui vire vers le bleu en fin de circulation. Le canal de sortie 56b présente une couleur rouge caractéristique uniquement du E129.

100µl d'eau est ensuite inséré dans le circuit fluidique par l'entrée 40 avec un débit de 100µl/min. Le canal d'entrée 56a présente la couleur de l'eau lorsque l'eau le traverse et le monolithe 30 présente une couleur de plus en plus bleue, le E129 passant vers le canal de sortie 56b. Seul le E133 est retenu dans le monolithe, le E129 est alors totalement élué.

400µl d'acétonitrile sont ensuite insérés dans le circuit fluidique par l'entrée 40 avec un débit de 100µl/min. Le E133 est alors élué, entrainant sa migration le long du monolithe vers la sortie 56b. Le monolithe est in fine blanc, ce qui indique une élution totale du E133.

Il est donc possible avec un tel dispositif de réaliser une chromatographie.

En variante, les portions 70a et 70b de la trace 62 pour former les microcanaux 56a et 56b peuvent être formées par l'utilisation d'un élément creux comportant une ouverture sur sa paroi latérale à la position de jonction avec le monolithe. La jonction entre l'élément creux et le monolithe peut alors être réalisée par une impression à la jonction. Dans ce cas, le procédé d'extraction de l'encre peut être similaire à celui décrit en relation avec l'exemple 2.

## Revendications

1. Procédé de fabrication d'un dispositif (10) pour la circulation d'un fluide sur au moins un chemin de circulation fluidique passant à travers un élément solide creux ou poreux (30) et au moins une partie d'un circuit fluidique (50), l'élément solide et la partie du circuit fluidique étant reliés fluidiquement entre eux, le procédé comprenant les étapes suivantes :
a) imprimer sur un support la trace (62) du circuit fluidique (50) avec une encre et disposer sur le support l'élément solide (30), l'encre étant jointive de l'élément solide (30) sur le chemin de circulation fluidique,
b) recouvrir l'encre ayant solidifiée et l'élément solide (30) avec un polymère réticulable (25), le polymère (25) étant non-miscible avec l'encre solidifiée;
c) réticuler le polymère (25) pour le solidifier; puis
d) extraire l'encre solidifiée pour former le chemin de circulation fluidique.

2. Procédé selon la revendication 1, comportant une étape de protection d'au moins une partie des pores ou du ou des creux de l'élément solide (30) le long du chemin de circulation fluidique par le remplissage préalable d'au moins une partie de l'élément solide (30), notamment le cœur de l'élément solide (30), mieux tout l'élément solide (30), par un agent protecteur, notamment identique à l'encre, empêchant la pénétration du polymère (25) dans l'élément solide (30) à l'étape de recouvrement b) et une étape d'extraction de l'agent protecteur après l'étape de réticulation du polymère c) pour permettre la circulation fluidique dans l'élément solide.

3. Procédé selon la revendication 1, dans lequel l'élément solide (30) est poreux, la réticulation du polymère (25) ayant lieu avant que le polymère (25) n'ait pu remplir les pores d'au moins une section de passage du chemin de circulation fluidique de l'élément solide.

4. Procédé selon l'une quelconque des revendications précédentes, configuré pour que le polymère (25) pénètre, en dehors de la zone de surface de l'élément solide (30) en contact avec l'encre, dans les pores de l'élément solide (30) entre l'étape de recouvrement b) et celle de réticulation c) sur une épaisseur de peau de l'élément solide (30) inférieure ou égale à 40%, mieux inférieure ou égale à 30%, encore mieux inférieure ou égale à 20%, préférentiellement inférieure ou égale à 10%, de la plus petite dimension de l'élément solide (30) en chaque section de passage du chemin de circulation fluidique dans l'élément solide (30).

5. Procédé selon l'une quelconque des revendications précédentes, dans lequel le support comporte un substrat (20) en un matériau hydrophobe par exemple choisi parmi choisi parmi : les polyimides (PI), les silicones dont le polydiméthylsiloxane (PDMS), le polypropylène (PP), le polytétrafluoroéthylène (PTFE), le copolymère d'oléfine cyclique (COC) ou un matériau hydrophile choisi parmi le silicium, le verre, la cellulose, les fibres de verre et optionnellement un ou plusieurs éléments de support (28 ; 28a, 28b) déposés sur le substrat (20), le support comportant au moins deux éléments de support (28a, 28b), notamment en un polymère réticulé identique à celui de l'étape b), sur le substrat (20) espacés entre eux d'une distance non nulle, le dispositif étant configuré pour que l'élément solide (30) soit disposé à l'étape a) à cheval sur les deux éléments de support (28a, 28b).

6. Procédé selon l'une quelconque des revendications 1 à 5, dans lequel le support comporte une cavité (29) de réception de l'élément solide (30) en surface, l'élément solide (30) étant disposé dans la cavité à l'étape a).

7. Procédé selon l'une quelconque des revendications précédentes, dans lequel l'élément solide (30) est jointif d'un microcanal (56, 58) sur le chemin de circulation fluidique.

8. Procédé selon l'une quelconque des revendications précédentes, dans lequel l'élément solide (30) s'étend sur le chemin de circulation fluidique de sorte que le chemin de circulation fluidique traverse l'élément solide (30) d'un point d'entrée (31, 32) à un point de sortie (31, 32), les points d'entrée et de sortie (31, 32) étant espacés entre eux d'une distance supérieure ou égale à 10%, mieux 50%, encore mieux la totalité, de la plus grande dimension de l'élément solide (30).

9. Procédé selon l'une quelconque des revendications précédentes, dans lequel l'élément solide (30) est creux, les extrémités ouvertes aux deux extrémités (31, 32) du creux de l'élément solide étant sur le chemin de circulation fluidique et l'axe central du creux s'étendant le long du chemin de circulation fluidique, le maintien du chemin de circulation fluidique dans le creux se faisant par bouchage des deux extrémités par un agent protecteur préalablement à l'ajout sur le support ou par l'encre du circuit fluidique jointe à l'extrémité creuse de l'élément solide durant l'étape a).

10. Procédé selon l'une quelconque des revendications précédentes, dans lequel l'élément solide (30) comporte un monolithe poreux à porosité hiérarchique, notamment autoporté, en particulier disposé nu sur le support (20), ou comporte un monolithe poreux (30) et une gaine extérieure de protection du monolithe poreux ouverte au niveau du point d'entrée (40) et du point de sortie (42) du chemin de circulation fluidique, l'encre étant jointive d'au moins une extrémité ouverte du tube ou du capillaire à l'étape a) du procédé.

11. Procédé selon l'une quelconque des revendications précédentes, dans lequel l'étape d'impression de la trace (62) et de disposition de l'élément solide (30) peut comporter une première impression d'encre (70a, 70b), la disposition de l'élément solide (30) sur le support (20) puis une deuxième impression d'encre (72a, 72b), notamment à la jonction entre l'élément solide (30) et la première impression d'encre (70a, 70b) pour former la jonction entre l'élément solide (30) et l'encre de la première impression.

12. Procédé selon l'une quelconque des revendications, dans lequel le procédé comporte l'impression d'au moins deux portions (70a, 70b) chacune continue et disjointes entre elles pour former la trace (62) du circuit fluidique, et la disposition de l'élément solide (30) à cheval sur les deux portions (70a, 70b)..

13. Procédé selon l'une quelconque des revendications précédentes, comportant la formation du monolithe poreux par un procédé de fabrication comportant :
- la formation d'un sol (5) comportant un précurseur sol-gel en solution aqueuse et, de préférence, un agent porogène,
- le remplissage au moins partiel d'une enceinte (12) et d'au moins un moule (15) contenu dans l'enceinte (12) en sol (5) formé précédemment, le moule (15) comportant au moins une ouverture (17) s'ouvrant dans le sol (5) après remplissage en sol,
- la formation d'une matrice sol-gel (22) dans l'enceinte (12) à partir du sol (5),
- l'extraction du moule (15) avec la matrice sol-gel (19) contenue dans le moule de l'enceinte, et
- la formation d'un monolithe poreux à partir de la matrice sol-gel,
la formation du sol, de la matrice sol-gel et du monolithe poreux se faisant par un procédé sol-gel.

14. Procédé selon l'une quelconque des revendications précédentes, dans lequel l'encre et/ou l'agent protecteur sont choisis parmi :
- les glycols linéaires dont la formule brute générique est C₂ₙH₄ₙ⁺²O₂ où n est un nombre entier positif supérieur ou égal à 1, de préférence tel que n = 3, 4 ou 5 ;
- le cyclohexanediol ;
- le biphényl ;
- le tri(cyclohexyl)méthane ;
- les alcools de formule brute CₙH₂ₙ⁺²O où n est un nombre entier positif supérieur ou égal à 1, de préférence tel que n = 10, 11 ou 12 ;
et leurs mélanges.

15. Procédé selon l'une quelconque des revendications précédentes, comportant le retrait d'au moins une partie du support, notamment du substrat (20).

## Patentansprüche

1. Verfahren zum Herstellen einer Vorrichtung (10) für die Zirkulation eines Fluids auf mindestens einem Fluidzirkulationsweg, der durch ein hohles oder poröses Festkörperelement (30) und mindestens einen Teil eines Fluidkreislaufs (50) verläuft, wobei das Festkörperelement und der Teil des Fluidkreislaufs untereinander fluidisch verbunden sind, wobei das Verfahren die folgenden Schritte umfasst:
a) Drucken der Spur (62) des Fluidkreislaufs (50) mit einer Tinte auf einen Träger und Anordnen des Festkörperelements (30) auf dem Träger, wobei die Tinte auf dem Fluidzirkulationsweg an das Festkörperelement (30) angrenzt,
b) Bedecken der Tinte, die sich verfestigt hat, und des Festkörperelements (30) mit einem vernetzbaren Polymer (25), wobei das Polymer (25) mit der verfestigten Tinte nicht mischbar ist;
c) Vernetzen des Polymers (25), um es zu verfestigen; dann
d) Extrahieren der verfestigten Tinte, um den Fluidzirkulationsweg zu bilden.

2. Verfahren nach Anspruch 1, umfassend einen Schritt des Schützens mindestens eines Teils der Poren oder des oder der Hohlräume des Festkörperelements (30) entlang des Fluidzirkulationswegs durch das vorherige Füllen mindestens eines Teils des Festkörperelements (30), insbesondere des Kerns des Festkörperelements (30), besser des gesamten Festkörperelements (30), mit einem Schutzmittel, das insbesondere identisch mit der Tinte ist, was das Eindringen des Polymers (25) in das Festkörperelement (30) bei dem Schritt des Bedeckens b) verhindert, und einen Schritt des Extrahierens des Schutzmittels nach dem Schritt des Vernetzens des Polymers c), um die Fluidzirkulation in dem Festkörperelement zu ermöglichen.

3. Verfahren nach Anspruch 1, wobei das Festkörperelement (30) porös ist, wobei das Vernetzen des Polymers (25) stattfindet, bevor das Polymer (25) die Poren mindestens eines Durchgangsquerschnitts des Fluidzirkulationswegs des Festkörperelements hat füllen können.

4. Verfahren nach einem der vorhergehenden Ansprüche, das dazu ausgestaltet ist, dass das Polymer (25), außerhalb des Oberflächenbereichs des Festkörperelements (30) in Kontakt mit der Tinte, zwischen dem Schritt des Bedeckens b) und dem des Vernetzens c) über eine Hautdicke des Festkörperelements (30) kleiner oder gleich 40 %, besser kleiner oder gleich 30 %, noch besser kleiner oder gleich 20 %, bevorzugt kleiner oder gleich 10 % des kleinsten Maßes des Festkörperelements (30) an jedem Durchgangsquerschnitt des Fluidzirkulationswegs in dem Festkörperelement (30) in die Poren des Festkörperelements (30) eindringt.

5. Verfahren nach einem der vorhergehenden Ansprüche, wobei der Träger ein Substrat (20) aus einem hydrophoben Material, das zum Beispiel ausgewählt ist aus: Polyimiden (PI), Silikonen, darunter Polydimethylsiloxan (PDMS), Polypropylen (PP), Polytetrafluorethylen (PTFE), Cyclo-Olefin-Copolymer (COC), oder aus einem hydrophilen Material, das aus Silizium, Glas, Cellulose, Glasfasern ausgewählt ist, und optional ein oder mehrere Trägerelemente (28; 28a, 28b), die auf das Substrat (20) aufgebracht sind, umfasst, wobei der Träger mindestens zwei Trägerelemente (28a, 28b), insbesondere aus einem vernetzten Polymer, das identisch mit dem des Schritts b) ist, auf dem Substrat (20) umfasst, die untereinander um einen Abstand von ungleich null beabstandet sind, wobei die Vorrichtung dazu ausgestaltet ist, dass das Festkörperelement (30) im Schritt a) rittlings auf den beiden Trägerelementen (28a, 28b) angeordnet wird.

6. Verfahren nach einem der Ansprüche 1 bis 5, wobei der Träger eine Kavität (29) zum Aufnehmen des Festkörperelements (30) an der Oberfläche umfasst, wobei das Festkörperelement (30) im Schritt a) in der Kavität angeordnet ist.

7. Verfahren nach einem der vorhergehenden Ansprüche, wobei das Festkörperelement (30) an einen Mikrokanal (56, 58) auf dem Fluidzirkulationsweg angrenzt.

8. Verfahren nach einem der vorhergehenden Ansprüche, wobei sich das Festkörperelement (30) auf dem Fluidzirkulationswegs erstreckt, so dass der Fluidzirkulationsweg das Festkörperelement (30) von einem Eintrittspunkt (31, 32) zu einem Austrittspunkt (31, 32) durchquert, wobei die Eintritts- und Austrittspunkte (31, 32) voneinander um einen Abstand größer oder gleich 10 %, besser 50 %, noch besser gleich dem gesamten größten Maß des Festkörperelements (30) beabstandet sind.

9. Verfahren nach einem der vorhergehenden Ansprüche, wobei das Festkörperelement (30) hohl ist, wobei die offenen Enden an beiden Enden (31, 32) des Hohlraums des Festkörperelements auf dem Fluidzirkulationsweg liegen und sich die Mittelachse des Hohlraums entlang des Fluidzirkulationswegs erstreckt, wobei das Halten des Fluidzirkulationswegs in dem Hohlraum durch Verschließen der beiden Enden mit einem Schutzmittel vor dem Hinzufügen auf dem Träger oder mit der Tinte des Fluidkreislaufs, die an das hohle Ende des Festkörperelements anschließt, während des Schritts a) erfolgt.

10. Verfahren nach einem der vorhergehenden Ansprüche, wobei das Festkörperelement (30) einen porösen Monolithen mit hierarchischer Porosität, insbesondere einen selbsttragenden, umfasst, der insbesondere nackt auf dem Träger (20) angeordnet ist, oder einen porösen Monolithen (30) und eine äußere Schutzhülle des porösen Monolithen, die an dem Eintrittspunkt (40) und dem Austrittspunkt (42) des Fluidzirkulationswegs offen ist, umfasst, wobei die Tinte im Schritt a) des Verfahrens an mindestens ein offenes Ende des Rohrs oder der Kapillare angrenzt.

11. Verfahren nach einem der vorhergehenden Ansprüche, wobei der Schritt des Druckens der Spur (62) und des Anordnens des Festkörperelements (30) einen ersten Tintenaufdruck (70a, 70b), das Anordnen des Festkörperelements (30) auf dem Träger (20) und dann einen zweiten Tintenaufdruck (72a, 72b) umfassen kann, insbesondere an dem Übergang zwischen dem Festkörperelement (30) und dem ersten Tintenaufdruck (70a, 70b), um den Übergang zwischen dem Festkörperelement (30) und der Tinte des ersten Aufdrucks zu bilden.

12. Verfahren nach einem der Ansprüche, wobei das Verfahren das Drucken von mindestens zwei Abschnitten (70a, 70b), die jeweils kontinuierlich und voneinander getrennt sind, um die Spur (62) des Fluidkreislaufs zu bilden, und das Anordnen des Festkörperelements (30) rittlings auf den beiden Abschnitten (70a, 70b) umfasst.

13. Verfahren nach einem der vorhergehenden Ansprüche, umfassend das Bilden des porösen Monolithen durch ein Herstellungsverfahren, umfassend:
- das Bilden eines Sols (5), das einen Sol-Gel-Vorläufer in wässriger Lösung und vorzugsweise einen Porenbildner umfasst,
- das mindestens partielle Füllen einer Kammer (12) und mindestens einer Form (15), die in der Kammer (12) enthalten ist, mit zuvor gebildetem Sol (5), wobei die Form (15) mindestens eine Öffnung (17) umfasst, die sich nach dem Füllen mit Sol in dem Sol (5) öffnet,
- das Bilden einer Sol-Gel-Matrix (22) in der Kammer (12) ausgehend von dem Sol (5),
- das Extrahieren der Form (15) mit der in der Form der Kammer enthaltenen Sol-Gel-Matrix (19), und
- das Bilden eines porösen Monolithen ausgehend von der Sol-Gel-Matrix,
wobei das Bilden des Sols, der Sol-Gel-Matrix und des porösen Monolithen durch ein Sol-Gel-Verfahren erfolgt.

14. Verfahren nach einem der vorhergehenden Ansprüche, wobei die Tinte und/oder das Schutzmittel ausgewählt sind aus:
- linearen Glykolen mit der allgemeinen Bruttoformel C₂ₙH₄ₙ⁺²O₂, wobei n eine positive ganze Zahl größer oder gleich 1 ist, vorzugsweise derart, dass n = 3, 4 oder 5 ist;
- Cyclohexandiol;
- Biphenyl;
- Tri(cyclohexyl)methan;
- Alkoholen mit der Bruttoformel CₙH₂ₙ⁺²O, wobei n eine positive ganze Zahl größer oder gleich 1 ist, vorzugsweise derart, dass n = 10, 11 oder 12 ist;
und Mischungen davon.

15. Verfahren nach einem der vorhergehenden Ansprüche, umfassend das Entfernen mindestens eines Teils des Trägers, insbesondere des Substrats (20).

## Claims

1. Method for manufacturing a device (10) for the flow of a fluid on at least one fluid flow path passing through a porous or hollow solid element (30) and at least a part of a fluidic circuit (50), the solid element and the part of the fluidic circuit being fluidically connected to one another, the method comprising the following steps:
a) printing a support with the course (62) of the fluidic circuit (50) with an ink and disposing the solid element (30) on the support, the ink being contiguous with the solid element (30) on the fluid flow path,
b) covering the solidified ink and the solid element (30) with a crosslinkable polymer (25), the polymer (25) being immiscible with the solidified ink;
c) crosslinking the polymer (25) to solidify it; then
d) extracting the solidified ink to form the fluid flow path.

2. Method according to Claim 1, comprising a step of protecting at least a part of the pores or of the hollow or hollows of the solid element (30) along the fluid flow path by filling at least a part of the solid element (30), in particular the core of the solid element (30), more preferably all of the solid element (30) beforehand with a protective agent, identical in particular with the ink, which prevents penetration of the polymer (25) into the solid element (30) in the covering step b), and a step of extracting the protective agent after the polymer crosslinking step c) to enable fluid flow in the solid element.

3. Method according to Claim 1, wherein the solid element (30) is porous, the polymer (25) being crosslinked before the polymer (25) has been able to fill the pores of at least one flow cross section of the fluid flow path of the solid element.

4. Method according to any one of the preceding claims, configured such that the polymer (25), outside the surface zone of the solid element (30) in contact with the ink, penetrates the pores of the solid element (30) between the covering step b) and the crosslinking step c) over a skin thickness of the solid element (30) of less than or equal to 40%, more preferably less than or equal to 30%, more preferably still less than or equal to 20%, preferentially less than or equal to 10%, of the smallest dimension of the solid element (30) in each flow cross section of the fluid flow path in the solid element (30).

5. Method according to any one of the preceding claims, wherein the support comprises a substrate (20) made of a hydrophobic material selected for example from the following: polyimides (PI), silicones, including polydimethylsiloxane (PDMS), polypropylene (PP), polytetrafluoroethylene (PTFE) and cyclic olefin copolymer (COC), or a hydrophilic material selected from silicon, glass, cellulose and glass fibers, and optionally one or more support elements (28; 28a, 28b) placed on the substrate (20), the support comprising at least two support elements (28a, 28b), in particular made of a crosslinked polymer identical with that of step b), on the substrate (20), which are spaced apart by a nonzero distance, the device being configured such that the solid element (30) is disposed in step a) straddling the two support elements (28a, 28b).

6. Method according to any one of Claims 1 to 5, wherein the support comprises a cavity (29) for receiving the solid element (30) on the surface, the solid element (30) being disposed in the cavity in step a).

7. Method according to any one of the preceding claims, wherein the solid element (30) is contiguous with a microchannel (56, 58) on the fluid flow pathway.

8. Method according to any one of the preceding claims, wherein the solid element (30) extends on the fluid flow path such that the fluid flow path crosses the solid element (30) from an entry point (31, 32) to an exit point (31, 32), the entry and exit points (31, 32) being spaced apart by a distance of greater than or equal to 10%, more preferably 50%, more preferably still the entirety, of the largest dimension of the solid element (30).

9. Method according to any one of the preceding claims, wherein the solid element (30) is hollow, the open ends at the two ends (31, 32) of the hollow of the solid element being in the fluid flow path and the central axis of the hollow extending along the fluid flow path, the fluid flow path being maintained in the hollow by plugging of the two ends by a protective agent before the addition on the support or by the ink of the fluidic circuit attached to the hollow end of the solid element during step a).

10. Method according to any one of the preceding claims, wherein the solid element (30) comprises a porous monolith having hierarchical porosity, in particular a self-supporting monolith, more particularly disposed bare on the support (20), or comprises a porous monolith (30) and a protective outer sheath for the porous monolith that is open at the entry point (40) and at the exit point (42) of the fluid flow path, the ink being contiguous with at least one open end of the tube or the capillary in step a) of the method.

11. Method according to any one of the preceding claims, wherein the step of printing the course (62) and disposing the solid element (30) may comprise a first printing of ink (70a, 70b) and the disposing of the solid element (30) on the support (20), then a second printing of ink (72a, 72b), in particular at the junction between the solid element (30) and the first printing of ink (70a, 70b), to form the junction between the solid element (30) and the ink of the first printing.

12. Method according to any one of the preceding claims, wherein the method comprises printing at least two respectively continuous portions (70a, 70b) separate from one another to form the course (62) of the fluidic circuit, and disposing the solid element (30) straddling the two portions (70a, 70b).

13. Method according to any one of the preceding claims, comprising the formation of the porous monolith by a manufacturing method comprising:
- the formation of a sol (5) comprising a sol-gel precursor in aqueous solution and, preferably, a pore former,
- the at least partial filling of an enclosure (12) and of at least one mold (15) contained in the enclosure (12) with sol (5) formed beforehand, the mold (15) comprising at least one opening (17) opening into the sol (5) after filling with sol,
- the formation of a sol-gel matrix (22) in the enclosure (12) from the sol (5),
- the extraction of the mold (15) with the sol-gel matrix (19) contained in the mold from the enclosure, and
- the formation of a porous monolith from the sol-gel matrix,
where the sol, the sol-gel matrix and the porous monolith are formed by a sol-gel method.

14. Method according to any one of the preceding claims, wherein the ink and/or the protective agent are selected from the following:
- linear glycols having the generic molecular formula C₂ₙH₄ₙ⁺²O₂ in which n is a positive integer greater than or equal to 1, preferably such that n = 3, 4 or 5;
- cyclohexanediol;
- biphenyl;
- tri(cyclohexyl)methane;
- alcohols of molecular formula CₙH₂ₙ⁺²O in which n is a positive integer greater than or equal to 1, preferably such that n = 10, 11 or 12;
and mixtures thereof.

15. Method according to any one of the preceding claims, comprising the withdrawal of at least a part of the support, in particular the substrate (20).
